# EUROPEAN PATENT APPLICATION

(11) **EP 4 436 322 A1**
(43) Date of publication of application: **25.09.2024**
(21) Application number: 22896048.0
(22) Date of filing: 16.11.2022
(51) Int. Cl.: H05K 1/18, H05K 1/11, H05K 3/46, H01L 23/12, H01L 23/28

(54) **CIRCUIT BOARD AND SEMICONDUCTOR PACKAGE COMPRISING SAME**

(30) Priority: 16.11.2021 KR 20210157852
(71) Applicant: LG INNOTEK CO., LTD., Seoul 07796 (KR)
(72) Inventor: SHIN, Jong Bae, Seoul 07796 (KR); LEE, Soo Min, Seoul 07796 (KR); JEONG, Jae Hun, Seoul 07796 (KR); JUNG, Ji Chul, Seoul 07796 (KR)
(74) Representative: M. Zardi & Co S.A.
(86) International application number: PCT/KR2022/018070
(87) International publication number: WO 2023/090843

(57) **Abstract**

A circuit board according to an embodiment includes a first insulating layer; a first circuit pattern layer disposed on one surface of the first insulating layer; a second insulating layer disposed on the one surface of the first insulating layer and including a cavity; and a through electrode disposed in a through hole passing through the first insulating layer, wherein the first circuit pattern layer includes a first pattern part including a portion that vertically overlaps an inner wall of the cavity, and wherein the through electrode includes a first through electrode disposed in a first through hole that vertically overlaps the first pattern part.

## Description

### [Technical Field]

An embodiment relates to a circuit board and a semiconductor package substrate including same.

### [Background Art]

A circuit board has a structure in which a mounting position of each device is determined and a circuit pattern connecting the device is printed on a surface of a flat plate in order to densely mount various kinds of devices on the flat plate, or it is composed of an embedded structure in which the device is embedded in the circuit board.

Recently, the circuit board is used in a multi-layered structure capable of high-density integration in order to realize miniaturization and multifunctionality of electronic components.

Generally, a conventional embedded circuit board forms a cavity for embedding a device using a drill bit, or subsidiary materials such as a release film are used to seat the device, or a cavity for embedding the device was formed using a sand blast.

However, the cavity included in a conventional circuit board has an inclination angle of the inner wall of 150° or more with respect to a bottom surface of the cavity, and the inclination angle of the inner wall must be considered in order to provide a mounting space for devices in the cavity, and accordingly, the space required for forming the cavity becomes relatively great. Accordingly, the conventional circuit board has a problem in that an integration density of circuits is reduced and an overall volume of the circuit board increases as the cavity formation space increases.

Recently, efforts have been made to develop improved 5G (5th generation) or higher communication systems or pre-5G communication systems to meet the demand for wireless data traffic. The 5G communication system uses ultra-high frequency (mm-Wave) bands (sub 6 GHz, 28 GHz, 38 GHz or higher frequencies) to achieve high data transfer rates. This high frequency band is called mm-Wave due to the length of the wavelength.

In addition, in order to alleviate the path loss of radio waves in the ultra-high frequency band and increase the transmission distance of radio waves, integration technologies such as beamforming, massive MIMO, and array antenna are being developed in 5G communication systems. Various chips constituting the AP module are mounted on the circuit board applied to the above 5G or higher (6G, 7G ~ etc.) communication system. At this time, in the above 5G or higher communication system, an overall product performance is determined depending on the performance of the mounted chip. At this time, the performance of the chip is closely related to the heat dissipation performance of the circuit board. For example, the performance of the chip may be determined by the heat dissipation performance of the circuit board, and the performance of the final product may be determined according to the performance of the chip.

Accordingly, there is a demand for a circuit board with improved heat dissipation performance while including a cavity in which the above devices can be placed.

### [Disclosure]

### [Technical Problem]

The embodiment provides a circuit board including a cavity in which a chip can be mounted and a semiconductor package including the same.

In addition, the embodiment provides a circuit board with an improved inclination angle of the inner wall of a cavity and a semiconductor package including the same.

In addition, the embodiment provides a circuit board and semiconductor package with improved heat dissipation performance.

The technical problems to be achieved in the proposed embodiment are not limited to the technical problems mentioned above, and other technical problems not mentioned in the embodiments will be clearly understood by those of ordinary skill in the art to which the embodiments proposed from the description below.

### [Technical Solution]

A circuit board according to an embodiment includes a first insulating layer; a first circuit pattern layer disposed on one surface of the first insulating layer; a second insulating layer disposed on the one surface of the first insulating layer and including a cavity; and a through electrode disposed in a through hole passing through the first insulating layer, wherein the first circuit pattern layer includes a first pattern part including a portion that vertically overlaps an inner wall of the cavity, and wherein the through electrode includes a first through electrode disposed in a first through hole that vertically overlaps the first pattern part.

In addition, an upper surface of the first pattern part is directly connected to a lower end of the inner wall of the cavity.

In addition, the circuit board further comprises a second circuit pattern layer disposed on the other surface of the first insulating layer, and wherein at least a portion of the second circuit pattern layer vertically overlaps the first through electrode.

In addition, the first pattern part includes a first portion vertically overlapping the inner wall of the cavity and having an upper surface in contact with the second insulating layer, and a second portion extending from the first portion and having an upper surface not in contact with the second insulating layer.

In addition, a thickness of the first portion of the first pattern part is thicker than a thickness of the second portion of the first pattern part.

In addition, the first circuit pattern layer includes a second pattern part disposed in a first upper surface region of the upper surface of the first insulating layer that vertically overlaps the cavity; and a third pattern part disposed in a second upper surface region of the upper surface of the first insulating layer that does not vertically overlap the cavity, wherein the first pattern part is disposed in a boundary region between the first upper surface region and the second upper surface region.

In addition, the first pattern part is disposed surrounding the boundary region between the first upper surface region and the second upper surface region.

In addition, the thickness of the first portion of the first pattern part is thicker than a thicknesses of each of the second pattern part and the third pattern part.

In addition, the thickness of the second portion of the first pattern part corresponds to a thickness of each of the second pattern part and the third pattern part.

In addition, the first portion and the second portion of the first pattern part include a first metal layer and a second metal layer, respectively, wherein a thickness of the first metal layer of the first portion is the same as a thickness of the first metal layer of the second portion, and wherein a thickness of the second metal layer of the first portion is greater than a thickness of the second metal layer of the second portion.

In addition, a difference between the thickness of the second metal layer of the first portion and the thickness of the second metal layer of the second portion corresponds to a thickness of the first metal layer of the first portion or the second metal layer of the second portion.

In addition, the through electrode includes a second through electrode disposed in a second through hole that vertically overlaps at least one of the second pattern part and the third pattern part, and the first through electrode is electrically separated from the second pattern part, the third pattern part, and the second through electrode.

In addition, the first circuit pattern layer includes a fourth pattern part having one end connected to the first pattern part and the other end extending toward a side edge of the upper surface of the first insulating layer, and the fourth pattern part is electrically separated from the second and third pattern parts.

In addition, the first portion of the first pattern part includes a concave portion covered with the second insulating layer and concave inward.

In addition, the first through electrode includes a plurality of first-first through electrodes commonly connected to the first pattern part and spaced apart from each other in a horizontal direction.

In addition, the circuit board further comprises a third insulating layer disposed below the first insulating layer; and a third through electrode disposed in a through hole passing through the third insulating layer and connected to the first through electrode.

In addition, the inner wall of the cavity includes a first inner wall adjacent to an upper surface of the second insulating layer and having a first inclination angle; and second inner wall extending from the first inner wall and having a second inclination angle different from the first inclination angle.

In addition, the first inclination angle with respect to a reference surface is smaller than the second inclination angle with respect to the reference surface, and the reference surface is an imaginary straight line parallel to the upper surface of the first insulating layer that vertically overlaps the cavity.

Meanwhile, the semiconductor package according to the embodiment comprises a first insulating layer; a first circuit pattern layer disposed on the first insulating layer; a second insulating layer disposed on the first insulating layer and including a cavity; and a through electrode disposed in a through hole passing through the first insulating layer, wherein the first circuit pattern layer including a first pattern part including a portion vertically overlapping the inner wall of the cavity; and a second pattern part spaced apart from the first pattern part and having an upper surface exposed through the cavity, a connection part disposed on the second pattern part; and an electronic device mounted on the connection part, wherein the through electrode includes a first through electrode connected to the first pattern part and a second through electrode connected to the second pattern part, and wherein the first through electrode is electrically separated from the electronic device, the second pattern part, and the second through electrode.

In addition, the semiconductor package is disposed within the cavity and includes a molding layer for molding the electronic device.

### [Advantageous Effects]

The circuit board according to the embodiment can improve heat dissipation characteristics. Specifically, the circuit board of the embodiment includes a first insulating layer, a second insulating layer, and a first circuit pattern layer. The second insulating layer includes a cavity. Additionally, the first circuit pattern layer includes a first-second pattern part disposed on a first upper surface region of the first insulating layer vertically overlapping the cavity, a first-third pattern part disposed in a second upper surface region that does not vertically overlap the cavity, and a first-first pattern part disposed in a boundary region of the first and second upper surface regions that vertically overlap a boundary region of the cavity. Additionally, the circuit board includes a through electrode disposed in a through hole passing through the first insulating layer. The through electrode includes a first through electrode connected to the first-first pattern part, and a second through electrode connected to the first-second pattern part or the first-third pattern part. At this time, the first through electrode is electrically separated from the second through electrode. The first through electrode is connected to the first-first pattern part, which is a dummy pattern used as a laser stopper, and functions as a heat dissipation electrode that transfers heat. The second through electrode functions as a signal electrode that transmits electrical signals. Accordingly, in the embodiment, heat generated from a chip mounted in the cavity can be dissipated to an outside using the first-first pattern part, which is the laser stopper, and accordingly, heat dissipation characteristics of the circuit board can be improved. Furthermore, the embodiment can improve the operating performance of the chip disposed in the cavity, thereby improving product reliability.

Additionally, the embodiment uses the first-first pattern part as a heat dissipation pattern for heat dissipation of the circuit board. For example, a chip is disposed in the cavity of a package substrate of a semiconductor package. At this time, the package substrate of a conventional semiconductor package does not have a pattern that functions to dissipate heat generated by the chip, and as a result, the heat dissipation characteristics deteriorate, which causes a problem in that the performance of the chip deteriorates. Additionally, the package substrate of a conventional semiconductor package includes a heat dissipation pattern for dissipating heat of the chip. However, the package substrate of a conventional semiconductor package forms the heat dissipation pattern through a separate manufacturing process, which has the problem of increasing manufacturing costs while complicating the manufacturing process.

In contrast, the embodiment uses the first-first pattern part used as a stopper in the laser process to form a cavity in the second insulating layer as a heat dissipation pattern. Accordingly, the embodiment can omit a separate process for creating the heat dissipation pattern, thereby simplifying the manufacturing process and reducing manufacturing costs.

Meanwhile, the first-first pattern part of the embodiment is disposed in the boundary region. The first-first pattern part includes a first portion vertically overlapping with the second insulating layer and at least a portion of the inner wall of the cavity, and a second portion vertically overlapping the cavity. The first portion of the first-first pattern part may vertically overlap at least a portion of the inner wall of the cavity. At this time, the first portion and the second portion of the embodiment may have a stepped portion. For example, a thickness of the first portion of the first-first pattern part may be greater than a thickness of the second portion. This is because the first portion of the first-first pattern part is not exposed to the etchant during the etching process of the seed layer and the etching is partially performed as only the second portion is exposed to the etching solution. At this time, the first portion of the first-first pattern part may have a thickness greater than the circuit pattern layers included in the circuit board. At this time, the embodiment may increase the thickness of at least a portion (e.g., the first portion) of the first-first pattern part that functions as a heat dissipation pattern compared to other patterns, thereby further improving heat dissipation characteristics. Furthermore, the embodiment does not perform an additional plating process only on the first portion of the first-first pattern part in order to increase the thickness of the first portion of the first pattern part than the thickness of other pattern parts. Specifically, the first portion of the first-first pattern part is plated under the same plating conditions as the other pattern parts, and has a greater thickness than the other pattern parts in a final structure. Accordingly, the embodiment can increase the thickness of the first portion of the first-first pattern part under the conditions that the manufacturing process does not become complicated and the product cost does not increase. Accordingly, the embodiment may improve user satisfaction.

Meanwhile, the second portion of the first-first pattern part of the embodiment is a portion exposed through the cavity together with the first-second pattern part. Accordingly, the first-second pattern part and the second portion of the first-first pattern part may be disposed in the cavity. At this time, if the thickness of the first-second pattern part and the second portion of the first-first pattern part are different, it can act as a factor that harms the product design, and furthermore, it can cause the problem of it being accepted as a defect. At this time, the thickness of the second portion of the first-first pattern part of the embodiment may correspond to the thickness of the first-second pattern part. The thickness of the second portion of the first-first pattern part may be the same as the thickness of the first-second pattern part. Through this, the embodiment can allow the first-first pattern part to have a partial step portion under conditions that do not affect the product design, thereby improving product design satisfaction.

Furthermore, the thickness of the first-first pattern part increases in a direction away from the cavity. That is, in the first-first pattern part, the first portion located farther from the cavity is thicker than the second portion. Through this, the embodiment can allow heat generated through the chip disposed in the cavity to be easily transferred to the outside of the cavity, and through this, heat dissipation characteristics can be further improved. Furthermore, the embodiment may allow the first portion of the first-first pattern part to be thicker than the thickness of other circuit pattern layers including the second portion. Accordingly, the embodiment can further improve heat transfer characteristics, thereby improving the reliability of the circuit board.

Additionally, the width of the second portion of the first-first pattern part in the embodiment is greater than the width of the first portion. For example, a planar area of the second portion of the first-first pattern part may be larger than a planar area of the first portion. For example, the second portion of the first-first pattern part may be disposed adjacent to the first-second pattern part disposed in a region that vertically overlaps the cavity. Through this, the embodiment can easily radiate heat generated from the chip mounted on the first-second pattern part to the outside through the second portion of the first-first pattern part, and thereby further improving the heat dissipation characteristics of the circuit board.

In addition, a plurality of first through electrodes are disposed on the first insulating layer of the embodiment, and the plurality of first through electrodes overlap in the vertical direction with the first-first pattern part and are spaced apart from each other in the horizontal direction. For example, a plurality of first-first through electrodes disposed on the first insulating layer overlap the first-first pattern part in a vertical direction and are commonly connected to the first-first pattern part.

Through this, the embodiment can use a plurality of first-first through electrodes connected to one first-first pattern part to branch and emit heat transferred from the first-first pattern part into a plurality of paths, and accordingly, heat dissipation characteristics can be further improved.

Meanwhile, the circuit board of the embodiment includes an extension pattern part that is directly connected to the first-first pattern part or connected to the pattern part connected to the first through electrode, and extends in an outer direction of the circuit board. The first through electrode provides a first heat transfer path that transfers heat in the vertical direction. Additionally, the extension pattern part provides a second heat transfer path that transfers heat in the horizontal direction. Specifically, ane end portion of the extension pattern part may be exposed to an outer side surface of the circuit board, and accordingly, heat may be emitted to the outer side surface of the circuit board. Through this, the embodiment can further improve the heat dissipation characteristics of the circuit board.

Meanwhile, in the embodiment, a process of forming a cavity in the second insulating layer is performed using the first-first pattern part used as the heat dissipation pattern as a laser stopper. Through this, the embodiment does not need to proceed with an additional process of separately forming the laser stopper, thereby simplifying the manufacturing process and reducing product costs.

Additionally, the cavity of the circuit board of the embodiment includes a first inner wall and a second inner wall having different inclination angles around an inflection portion. At this time, a first inclination angle of the first inner wall with respect to the reference surface is smaller than a second inclination angle of the second inner wall with respect to the reference surface. And, the first inner wall forms an outermost portion of the cavity. Accordingly, the embodiment allows the first inner wall with a relatively small inclination angle to form an outermost region of the cavity. Accordingly, the embodiment can dramatically reduce the space occupied by the cavity, thereby reducing the size of the circuit board.

Additionally, the package substrate of the semiconductor package of the embodiment includes an electronic device such as a chip mounted in the cavity, and a molding layer for molding the cavity. At this time, the molding layer contacts the first inner wall and the second inner wall of the cavity. At this time, the inclination angles of the first inner wall and the second inner wall of the embodiment have different inclination angles around the inflection portion. Accordingly, the embodiment can increase a bonding area between the inner wall of the cavity and the molding layer, thereby improving bonding strength between the circuit board and the molding layer.

Additionally, the embodiment proceeds with a process of forming a cavity using a portion of the circuit pattern layer as a mask. At this time, in order to form a cavity using the laser, a first mask (the first-first pattern part) that determines a depth of the cavity in a lower region of the cavity and a second mask that surrounds an upper region of the cavity at a location adjacent to the upper region of the cavity are required. At this time, in the comparative example, a process of forming the cavity is performed using a separate pattern as the mask. Unlike this, the embodiment uses a portion of the circuit pattern layer as a mask for processing the cavity. Through this, the embodiment can omit a separate process for forming the mask, and thus additional processes for forming and removing the mask can be omitted.

Meanwhile, in the embodiment, at least a portion of the first mask overlaps with at least a portion of the second mask in a vertical direction. At this time, the first mask and the second mask in the comparative example do not overlap in the vertical direction. Accordingly, in the comparative example, laser processing is performed on a region outside the second mask due to processing deviation in the laser process, and as a result, a problem may occur in which part of the upper surface of the first insulating layer is damaged by the laser. Unlike this, in the embodiment, a laser processing process for forming a cavity is performed in a state in which at least a portion of the first mask and the second mask are arranged to overlap each other in the vertical direction. Accordingly, the embodiment can accurately form a cavity only in the desired region, thereby improving product reliability.

### [Description of Drawings]

FIG. 1A and 1B are views showing a circuit board according to an embodiment.
FIG. 2A is an enlarged view of a cavity region of FIG. 1A.
FIG. 2B is an enlarged view of a cavity region of FIG. 1B.
FIG. 2C is a photomicrograph showing a product photo of a circuit board according to an embodiment.
FIG. 3 is view showing a detailed layer structure of a first through electrode shown in FIG. 1A or FIG. 1B.
FIG. 4 is a view showing a shape of a first-first pattern part according to an embodiment in more detail.
FIG. 5 is a plan view of an upper surface of a first insulating layer according to one embodiment.
FIG. 6 is a view showing a circuit board according to a second embodiment.
FIG. 7 is a view showing a modified example of a first through electrode according to an embodiment.
FIG. 8 is a view showing a first circuit pattern layer of a circuit board according to another embodiment.
FIG. 9 is a view showing a modified example of a circuit board according to an embodiment.
FIG. 10 is a view showing a semiconductor package according to a first embodiment.
FIG. 11 is a view showing a semiconductor package according to a second embodiment.
FIGS. 12A to 120 are views showing a method of manufacturing a circuit board method according to an embodiment in order of processes.

### [DETAILED DESCRIPTION OF THE EMBODIMENTS]

Hereinafter, preferred embodiments of the present invention will be described in detail with reference to the accompanying drawings.

However, the technical spirit of the present invention is not limited to some embodiments described, but may be implemented in various different forms, and, as long as it is within the scope of the technical spirit of the present invention, one or more of the components may be selectively combined and substituted between the embodiments.

In addition, terms (including technical and scientific terms) used in the embodiments of the present invention may be interpreted as meanings that can be generally understood by those of ordinary skill in the art to which the present invention pertains unless explicitly defined and described, and the meanings of commonly used terms such as predefined terms may be interpreted in consideration of the contextual meaning of the related art. In addition, the terms used in the embodiments of the present invention are for describing the embodiments and are not intended to limit the present invention.

In this specification, the singular may also include the plural unless specifically stated in the phrase, and when it is described as "A and (and) at least one (or more than one) of B and C", it may include one or more of all combinations that can be combined with A, B, and C. In addition, in describing the components of the embodiment of the present invention, terms such as first, second, A, B, (a), (b), etc. may be used.

These terms are only used to distinguish the component from other components, and are not limited to the essence, order, or order of the component by the term. And, when it is described that a component is 'connected', 'coupled' or 'contacted' to another component, the component is not only directly connected, coupled or contacted to the other component, but also with the component it may also include a case of 'connected', 'coupled' or 'contacted ' due to another element between the other elements.

In addition, when it is described as being formed or disposed on "above (on) or below (under)" of each component, the above (on) or below (under) is one as well as when two components are in direct contact with each other. Also includes a case in which another component as described above is formed or disposed between two components. In addition, when expressed as "above (up) or below (under)", it may include not only the upward direction but also the meaning of the downward direction based on one component.

Hereinafter, an embodiment of the present invention will be described in detail with reference to the accompanying drawings.

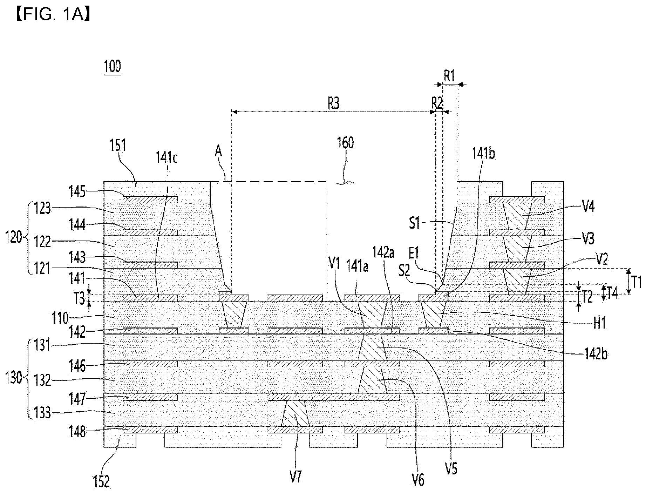

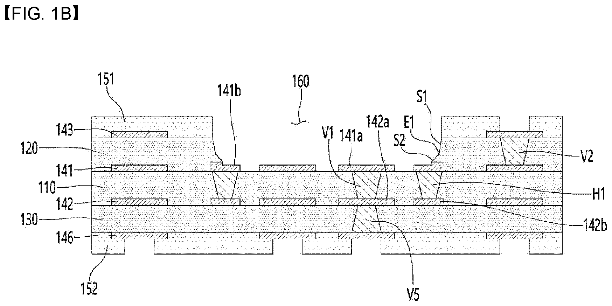

FIG. 1A and 1B are views showing a circuit board according to an embodiment. Specifically, FIG. 1A is a view showing a circuit board having a multi-layer cavity according to an embodiment, and FIG. 1B is a view showing a circuit board having a single-layer cavity according to an embodiment.

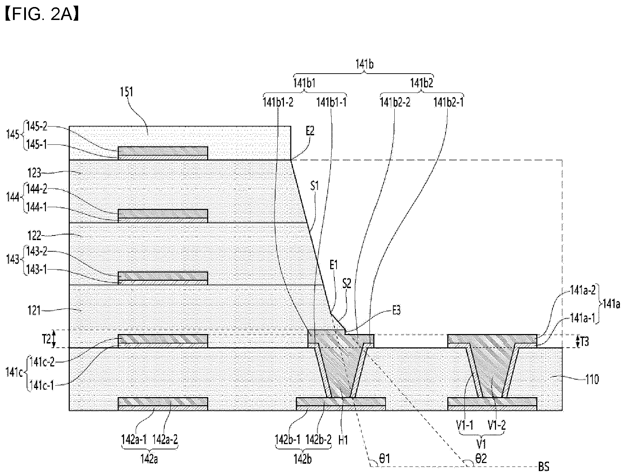

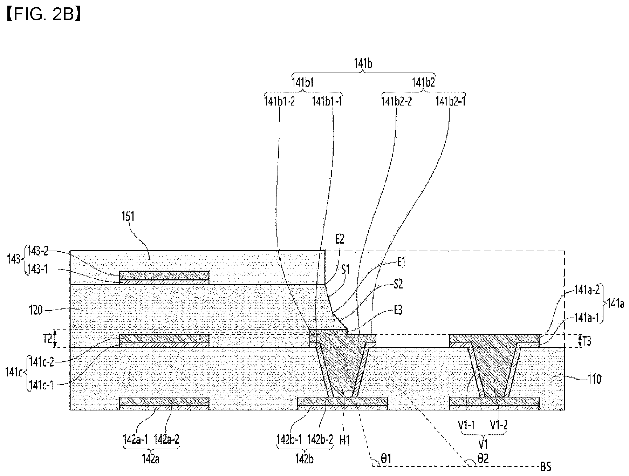

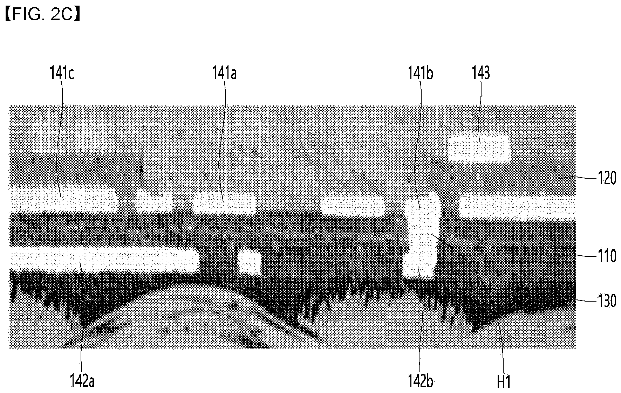

FIG. 2A is an enlarged view of a cavity region of FIG. 1A, FIG. 2B is an enlarged view of a cavity region of FIG. 1B, and FIG. 2C is a photomicrograph showing a product photo of a circuit board according to an embodiment.

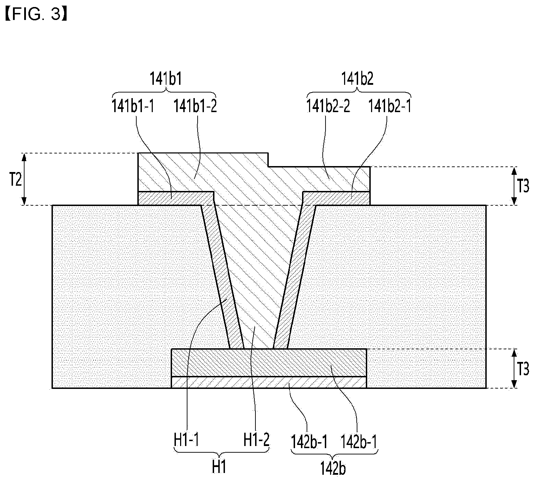

In addition, FIG. 3 is view showing a detailed layer structure of a first through electrode shown in FIG. 1A or FIG. 1B.

Hereinafter, a circuit board according to an embodiment will be described with reference to FIGS. 1A, 1B, 2A, 2B, 2C, and 3.

The circuit board 100 according to the embodiment includes a first insulating layer 110, a second insulating layer 120, a third insulating layer 130, circuit pattern layers 141, 142, 143, 144, 145, 146, 147 and 148, through electrodes V1, V2, V3, V4, V5, V6, V7 and H1, and protective layers 151 and 152. The through electrodes V1, V2, V3, V4, V5, V6, V7 and H1 can be divided into a first through electrode and a second through electrode depending on their function. The first through electrode may refer to H1, which will be described below. The second through electrode may refer to V1, V2, V3, V4, V5, V6, and V7, which will be described below. The second through electrode may refer to a signal wire that functions to transmit signals in the circuit board of the embodiment.

The first through electrode is not electrically connected to the second through electrode. As an example, the first through electrode may be referred to as a dummy electrode. As another example, the first through electrode may be said to be a heat dissipation electrode. Specifically, the first through electrode does not perform a signal transmission function, but may perform a heat transfer function of transferring heat generated from the circuit board of the embodiment. This will be explained in more detail below.

The first insulating layer 110 may be an insulating layer disposed at an inside of the circuit board 100. As an example, the first insulating layer 110 may refer to an insulating layer disposed at a center among all insulating layers constituting a circuit board. However, the embodiment is not limited thereto, and the first insulating layer 110 may be an insulating layer disposed biased toward an upper side or a lower side of the circuit board rather than the center.

Referring to FIG. 1A, a second insulating layer 120 is disposed on the first insulating layer 110. As an example, the second insulating layer 120 may be composed of multiple layers. As an example, the second insulating layer 120 may have a three-layer structure, but is not limited thereto. A third insulating layer 130 is disposed below the first insulating layer 110. The third insulating layer 130 may be composed of multiple layers. As an example, the third insulating layer 130 may have a three-layer structure, but is not limited thereto.

At this time, the first insulating layer 110, the second insulating layer 120, and the third insulating layer 130 may be divided based on a cavity 160. For example, the second insulating layer 120 may refer to an insulating layer including a cavity 160. The first insulating layer 110 is adjacent to the second insulating layer 120 and may refer to an insulating layer on a surface of which a mounting pad on which a chip is mounted is disposed while vertically overlapping the cavity 160. And, the third insulating layer 130 may refer to an insulating layer disposed below the first insulating layer 110.

For example, the second insulating layer 120 includes a second-first insulating layer 121 disposed on the first insulating layer 110, a second-second insulating layer 122 disposed on the second-first insulating layer 121, and a second-third insulating layer 123 disposed on the second-second insulating layer 122.

At this time, although the second insulating layer 120 is shown in the drawing as having a three-layer structure, the embodiment is not limited thereto. That is, the second insulating layer 120 may have a two-layer structure, or alternatively, the second insulating layer 120 may have a four-layer or more structure.

In addition, the third insulating layer 130 includes a third-first insulating layer 131 disposed below the first insulating layer 110, a third-second insulating layer 132 disposed below the third-first insulating layer 131, and a third-third insulating layer 133 disposed below the third-second insulating layer 132. At this time, although the third insulating layer 130 is shown in the drawing as having a three-layer structure, the embodiment is not limited thereto. For example, the third insulating layer 130 may have a two-layer structure, or alternatively, the third insulating layer 130 may have a four-layer or more structure.

In addition, the circuit board 100 in FIG. 1A is shown as having a 7-layer structure based on the number of insulating layers, but the circuit board 100 is not limited thereto. For example, the circuit board 100 may have a number of layers of 6 or less based on the number of insulating layers, or alternatively, the circuit board 100 may have a number of layers of 8 or more.

Meanwhile, referring to FIG. 1B, at least one of the second insulating layer 120 and the third insulating layer 130 may have a single-layer structure. For example, the second insulating layer 120 may have a one-layer structure. For example, the third insulating layer 130 may have a one-layer structure.

And, a cavity 160 is formed in the second insulating layer 120 of the circuit board of the embodiment. The second insulating layer 120 is formed passing through the second insulating layer 120.

Accordingly, the cavity 160 in the structure of FIG. 1A may include a plurality of parts as it passes through a plurality of insulating layers. Additionally, the cavity 160 in the structure of FIG. 1B may include a single part as it passes through a single insulating layer.

That is, a difference between FIGS. 1A and 1B lies in the number of layers of the second insulating layer 120 in which the cavity 160 is formed. That is, the difference between FIGS. 1A and 1B is whether the cavity 160 is formed in the second insulating layer 120 having a two-layer or more layer structure or in the second insulating layer 120 having a one-layer structure.

The first insulating layer 110, the second insulating layer 120, and the third insulating layer 130 are boards on which an electric circuit whose wiring can be changed is formed, and it may include a printed circuit board and an insulating substrate made of an insulating material capable of forming circuit patterns on the surface thereof.

For example, the first insulating layer 110 may be rigid or flexible. For example, the first insulating layer 110 may include glass or plastic. Specifically, the first insulating layer 110 may include a chemically tempered/semi-tempered glass, such as soda lime glass, aluminosilicate glass, etc., a tempered or flexible plastic such as polyimide (PI), polyethylene terephthalate (PET), propylene glycol (PPG), polycarbonate (PC), etc., or sapphire.

In addition, the first insulating layer 110 may include an optically isotropic film. As an example, the first insulating layer 110 may include cyclic olefin copolymer (COC), cyclic olefin polymer (COP), optically isotropic PC, optically isotropic polymethylmethacrylate (PMMA), or the like.

In addition, the first insulating layer 110 may be partially bent while having a curved surface. That is, the first insulating layer 110 may partially have a plane and may partially be bent while having a curved surface. Specifically, an end portion of the first insulating layer 110 may be bent while having a curved surface, or bent or crooked while having a surface with a random curvature.

In addition, the first insulating layer 110 may be a flexible substrate having flexibility. In addition, the first insulating layer 110 may be a curved or bent substrate.

Meanwhile, the second insulating layer 120 and the third insulating layer 130 may be made of prepreg or resin coated copper (RCC).

As an example, the first insulating layer 110 may include prepreg, and the second insulating layer 120 and the third insulating layer 130 may include RCC. As another example, the first insulating layer 110, the second insulating layer 120, and the third insulating layer 130 may prepreg. As another example, one of the plurality of layers constituting the second insulating layer 120 and the third insulating layer 130 may include prepreg, and at least the other one may include RCC.

Preferably, the second insulating layer 120 and the third insulating layer 130 may include RCC, and through this, a thickness of the insulating layer can be reduced to enable slimming of the circuit board and improve dielectric constant.

That is, the insulating layer constituting the circuit board in the comparative example was composed only of prepreg (PPG) containing glass fiber. At this time, the circuit board in the comparative example has limitations in reducing a thickness of the insulating layer due to the glass fibers that make up the prepreg. For example, when the thickness of the prepreg decreases, glass fibers included in the prepreg may be electrically connected to the circuit pattern layer disposed on the surface of the prepreg, which may result in physical reliability problems such as cracks. Therefore, when reducing the thickness of the insulating layer composed of prepreg, destruction of the dielectric may occur or damage to the circuit pattern may occur. Accordingly, the circuit board in the comparative example has limitations in reducing the thickness of the insulating layer due to the glass fibers constituting the prepreg, thereby limiting the ability to slim the circuit board.

Additionally, the circuit board in the comparative example has a relatively high dielectric constant because the insulating layer is composed of only prepreg containing glass fiber. At this time, as the dielectric constant of the insulating layer increases, there is a problem that it becomes difficult to use it as a high-frequency circuit board. That is, because the circuit board in the comparative example has a high dielectric constant of glass fiber, a phenomenon in which the dielectric constant is destroyed in the high frequency band occurs.

Accordingly, the embodiment allows at least one insulating layer among the plurality of insulating layers of the circuit board to be formed of RCC having a lower dielectric constant than the prepreg. Through this, the embodiment can provide a circuit board with high signal transmission characteristics even in a high frequency band while enabling slimming of the circuit board.

The second insulating layer 120 and the third insulating layer 130 may each have a thickness of 5 µm to 20 µm. For example, when the second insulating layer 120 has a plurality of layer structure, a thickness of each layer of the second insulating layer 120 may be 5 µm to 20 µm. Additionally, when the third insulating layer 130 has a plurality of layer structure, each layer thickness of the plurality of third insulating layers 130 may be 5 µm to 20 µm.

Through this, in the embodiment, the second insulating layer 120 including the cavity 160 is composed of RCC, thereby dramatically reducing the thickness of the printed circuit board compared to the comparative example composed of prepreg. Accordingly, the embodiment can reduce the thickness of the circuit board by more than 5µm compared to the comparative example by using an RCC made of a low dielectric constant material.

However, in the circuit board of the embodiment, even if the second insulating layer 120 is constructed using RCC with a low dielectric constant of 2.7, which is a 10% improvement from the prepreg's dielectric constant (Dk) of 3.0, the reduction in thickness is only 10% compared to the comparative example. Accordingly, in the embodiment, a cavity 160 is formed in a chip mounting region where a chip such as an electronic device is mounted, and the chip is mounted in the formed cavity 160.

At this time, at least one of the first insulating layer 110, the second insulating layer 120, and the third insulating layer 130 expresses electrical wiring connecting circuit components as a wiring diagram based on circuit design, and can reproduce electrical conductors on insulating materials. In addition, at least one of the first insulating layer 110, the second insulating layer 120, and the third insulating layer 130 can mount electrical components and form wiring that connects them electrically, and can mechanically fix components other than the electrical connection function of the components.

Circuit pattern layers may be disposed on the first insulating layer 110, second insulating layer 120, and third insulating layer 130.

For example, a first circuit pattern layer 141 may be disposed on an upper surface of the first insulating layer 110. For example, the second circuit pattern layer 142 may be disposed on a lower surface of the first insulating layer 110.

Additionally, a circuit pattern layer may be disposed on the second insulating layer 120. For example, when the second insulating layer 120 has a structure of FIG. 1A with a plurality of layers, the circuit pattern layer include a third circuit pattern layer including a third-first circuit pattern layer 143 disposed on an upper surface of a second-first insulating layer 121, a third-second circuit pattern layer 144 disposed on an upper surface of the second-second insulating layer 122 and a third-third circuit pattern layer 145 disposed on an upper surface of the second-third insulating layer 123. In addition, when the second insulating layer 120 has a single-layer structure as shown in FIG. 1B, it may include a third circuit pattern layer 143 disposed on the upper surface of the second insulating layer 120..

Additionally, a circuit pattern layer may be disposed on the third insulating layer 130. For example, when the third insulating layer 130 has a structure of FIG. 1A with a plurality of layers, the circuit pattern layer may include a fourth circuit pattern layer including a fourth-first circuit pattern layer 146 disposed on a lower surface of the third-first insulating layer 131, a fourth-second circuit pattern layer 147 disposed on a lower surface of the third-second insulating layer 132, and a fourth-third circuit pattern layer 148 disposed on a lower surface of the third-third insulating layer 133. In addition, when the third insulating layer 130 has a single-layer structure as shown in FIG. 1B, it may include a fourth circuit pattern layer 146 disposed on the lower surface of the third insulating layer 130.

Additionally, each of the circuit pattern layers may include a plurality of pattern parts arranged to be spaced apart from each other on the surface of each insulating layer.

Meanwhile, the circuit pattern layers 141, 142, 143, 144, 145, 146, 147, and 148 as described above are wirings that transmit electrical signals, and may be formed of a metal material having high electrical conductivity.

To this end, the circuit pattern layers 141, 142, 143, 144, 145, 146, 147, and 148 may be formed of at least one metal material selected from gold (Au), silver (Ag), platinum (Pt), titanium (Ti), tin (Sn), copper (Cu), and zinc (Zn). In addition, the circuit pattern layers 141, 142, 143, 144, 145, 146, 147, and 148 may be formed of a paste or solder paste including at least one metal material selected from gold (Au), silver (Ag), platinum (Pt), titanium (Ti), tin (Sn), copper (Cu), and zinc (Zn) having excellent bonding strength. Preferably, the circuit pattern layers 141, 142, 143, 144, 145, 146, 147, and 148 may be formed of copper (Cu), which has high electrical conductivity and is relatively inexpensive.

The circuit pattern layers 141, 142, 143, 144, 145, 146, 147, and 148 may be formed by an additive process, a subtractive process, a modified semi additive process (MSAP) and a semi additive process (SAP) method, which is a typical circuit board manufacturing process, and a detailed description thereof will be omitted herein.

The first circuit pattern layer 141 can be divided into three pattern parts depending on arrangement regions. The arrangement region may be divided based on the cavity 160 formed in the second insulating layer 120.

For example, an upper surface of the first insulating layer 110 may largely include a first upper surface region and a second upper surface region.

The first upper surface region may refer to a region of the upper surface of the first insulating layer 110 that vertically overlaps the cavity 160. In addition, the second upper surface region may refer to a region of the upper surface of the first insulating layer 110 that does not vertically overlap the cavity 160 and vertically overlaps the second insulating layer 120. For example, the second upper region may mean a region covered with the second insulating layer 120.

Additionally, the first insulating layer 110 may include a boundary region between the first upper surface region and the second upper surface region. The boundary region may overlap at least a portion of each of the first upper surface region and the second upper surface region. Specifically, the boundary region may refer to a region between the first upper surface region and the second upper surface region. Accordingly, a portion of the first upper surface region and a portion of the second upper surface region may be included in the boundary region.

For example, the boundary region may include a first boundary region that is part of the second upper surface region and a second boundary region that is part of the first upper surface region. For example, at least a portion of the first boundary region may vertically overlap an inner wall of the cavity 160.

The first circuit pattern layer 141 includes a first-second pattern part 141a disposed in the first upper surface region of the first insulating layer 110, a first-third pattern part 141c disposed in the second upper surface region, and a first-first pattern part 141b disposed in the boundary region.

The first-second pattern part 141a may mean a pattern in which an upper surface is exposed through the cavity 160 while vertically overlapping the cavity 160. For example, the first-second pattern part 141a may also be referred to as a chip mounting pad for mounting a chip disposed in the cavity 160.

The first-third pattern part 141c may refer to a pattern covered by the second insulating layer 120.

Specifically, the first-second pattern part 141a is electrically separated from the first-first pattern part 141b and is disposed in a region of the first upper surface of the first insulating layer 110 vertically overlapping the cavity 160. The first-second pattern part 141a is a mounting pad on which a chip is mounted, and thus may have a structure exposed through the cavity 160.

Furthermore, the first-third pattern part 141c may be physically and electrically separated from the first-first pattern part 141b and may be disposed in a region of the second upper surface of the first insulating layer 110 vertically overlapping the second insulating layer 120 without vertically overlapping the cavity 160. For example, the first-third pattern part 141c may be referred to as a buried pattern buried in the second insulating layer 120 as it is covered by the second insulating layer 120. Meanwhile, the first-third pattern part 141c may be physically and electrically separated from the first-first pattern part 141b and may be physically or electrically connected to the first-second pattern part 141a. For example, the first-third pattern part 141c may be electrically connected to the first-second pattern part 141a, thereby transmitting an output signal of a chip mounted on the first-second pattern part 141a or an input signal input to the chip.

Additionally, the first-first pattern part 141b may refer to a pattern formed in the boundary region of the cavity 160. For example, the first-first pattern part 141b may also be referred to as a mask pattern used as a laser stopper in a laser process for forming the cavity 160 in the second insulating layer 120.

The first-first pattern part 141b may not be electrically connected to the first-second pattern part 141a and the first-third pattern part 141c. For example, the first-first pattern part 141b may be electrically and physically separated from the first-second pattern part 141a and the first-third pattern part 141c.

Meanwhile, at least a portion of the first-second pattern part 141a and the first-first pattern part 141b may be disposed in the cavity 160. For example, the first-second pattern part 141a and the first-first pattern part 141b may overlap the cavity 160 in a vertical direction and a horizontal direction.

At this time, the first-first pattern part 141b is disposed in the boundary region, and accordingly, at least a portion may vertically overlap the second insulating layer 120 , and the remaining portion may vertically overlap the cavity 160.

For example, in a state before the chip is mounted in the cavity 160, the first-first pattern part 141b includes a first portion 141b1 covered with the second insulating layer 120, and a second portion 141b2 extending from the first portion 141b1 in a direction in which the cavity 160 is formed and exposed through the cavity 160.

At this time, the first-first pattern part 141b may include a region of which a thickness is changed. For example, the first-first pattern part 141b may include a region in which a height of the upper surface is changed. For example, the first-first pattern part 141b may include a region whose thickness becomes thinner in the direction toward the cavity 160. For example, the first-first pattern part 141b may include a step region.

Specifically, a thickness of the first portion 141b1 and the second portion 141b2 of the first-first pattern part 141b may be different from each other. For example, a height of the upper surface of the first portion 141b1 of the first-first pattern part 141b and the upper surface of the second portion 141b2 may be different from each other.

For example, a process of manufacturing a general circuit pattern layer includes a first process of forming a pattern by forming an electrolytic plating layer on a seed layer, and a second process of removing the seed layer.

In this case, the first portion 141b1 of the first-first pattern part 141b may be a region in which the electroplating layer is not etched in a second process of removing the seed layer, and the second portion 141b2 may mean a region in which the electroplating layer is etched in a second process of removing the seed layer.

That is, in order to use a seed layer vertically overlapping with the cavity 160 among the seed layers disposed on the upper surface of the first insulating layer 110 as a mask pattern, the embodiment allows a process of removing a part of the seed layer to proceed after the cavity 160 is formed. At this time, the second portion 141b2 of the first-first pattern part 141b vertically overlaps the cavity 160, and accordingly, the electrolytic plating layer is etched after the cavity 160 is formed. In contrast, the first portion 141b1 of the first-first pattern part 141b is covered with the second insulating layer 120 without vertically overlapping the cavity 160, and for this reason, the electrolytic plating layer is not etched after the cavity 160 is formed.

Accordingly, the first portion 141b1 and the second portion 141b2 of the first-first pattern part 141b may have a step corresponding to a thickness of the seed layer. For example, a thickness of the first portion 141b1 of the first-first pattern part 141b may be greater than the thickness of the second portion 141b2. For example, the thickness of the second portion 141b2 of the first-first pattern part 141b may be thinner than the thickness of the first portion 141b1 of the first-first pattern part 141b by as much as the thickness of the seed layer. For example, the thickness of the first portion 141b1 of the first-first pattern part 141b may be thicker than the thickness of the second portion 141b2 of the first-first pattern part 141b by the thickness of the seed layer.

At this time, the second portion 141b2 of the first-first pattern part 141b is a portion exposed through the cavity 160 together with the first-second pattern part 141a. Accordingly, the first-second pattern part 141a and the second portion 141b2 of the first-first pattern part 141b may be disposed in the cavity 160. At this time, if the thickness of the first-second pattern part 141a and the second portion 141b2 of the first-first pattern part 141b are different from each other, it may act as a factor that degrades the product design, and furthermore, there may be a problem of accepting it as a defect. Accordingly, the thickness of the second portion 141b2 of the first-first pattern part 141b in the embodiment may correspond to the thickness of the first-second pattern part 141a. The thickness of the second portion 141b2 of the first-first pattern part 141b may be the same as the thickness of the first-second pattern part 141a. Through this, the embodiment can allow the first-first pattern part 141b to have a partial step to the extent that it does not affect the product design.

Furthermore, the first portion 141b1 of the first-first pattern part 141b is not exposed through the cavity 160, and has a thickness thicker than the second portion 141b2 of the first-second pattern part 141a and the first-first pattern part 141b. Accordingly, an embodiment may improve heat dissipation characteristics of the circuit board as the thickness of the first portion 141b1 of the first-first pattern part 141b is thicker than that of other parts within a range that does not affect a product design.

Preferably, the embodiment uses the first-first pattern part 141b as a heat dissipation pattern for heat dissipation of the circuit board. For example, a chip is disposed in the cavity 160 of a package substrate of a semiconductor package. At this time, the package substrate of a conventional semiconductor package does not have a pattern that functions to dissipate heat generated by the chip, and as a result, the heat dissipation characteristics deteriorate, which causes a problem in that the performance of the chip deteriorates. Additionally, the package substrate of a conventional semiconductor package includes a heat dissipation pattern for dissipating heat of the chip. However, the package substrate of a conventional semiconductor package forms the heat dissipation pattern through a separate manufacturing process, which has the problem of increasing manufacturing costs while complicating the manufacturing process.

In contrast, the embodiment uses the first-first pattern part 141b used as a stopper in the laser process to form a cavity 160 in the second insulating layer 120 as a heat dissipation pattern. Accordingly, the embodiment can omit a separate process for creating the heat dissipation pattern, thereby simplifying the manufacturing process and reducing manufacturing costs.

Additionally, the thickness of the first-first pattern part 141b increases in a direction away from the cavity 160. That is, in the first-first pattern part 141b, the first portion 141b1 located farther from the cavity 160 is thicker than the second portion 141b2. Through this, the embodiment can allow heat generated through the chip disposed in the cavity 160 to be easily transferred to the outside of the cavity 160, and through this, heat dissipation characteristics can be further improved. Furthermore, the embodiment allows the first portion 141b1 of the first-first pattern part 141b to be thicker than the thickness of other circuit pattern layers including the second portion 141b2. Accordingly, the embodiment can further improve heat transfer characteristics, thereby improving the reliability of the circuit board.

Additionally, the width of the second portion 141b2 of the first-first pattern part 141b in the embodiment is greater than the width of the first portion 141b1. For example, the planar area of the second portion 141b2 of the first-first pattern part 141b may be larger than the planar area of the first portion 141b1. For example, the second portion 141b2 of the first-first pattern part 141b may be disposed adjacent to the first-second pattern part 141a disposed in a region that vertically overlaps the cavity 160. Through this, the embodiment can easily radiate heat generated from the chip mounted on the first-second pattern part 141a to the outside through the second portion 141b2 of the first-first pattern part 141b, and accordingly the heat dissipation characteristics of the circuit board can be further improved.

A layer structure and thickness relationship of the circuit pattern layers of the circuit board of the embodiment, including each pattern part of the first circuit pattern layer 141, will be further described below.

Meanwhile, the circuit board of the embodiment includes through electrodes formed in through holes (not shown) that passes through the first insulating layer 110, the second insulating layer 120, and the third insulating layer 130, respectively.

At this time, the through electrode may be divided into a first through electrode and a second through electrode depending on its function.

The first through electrode and the second through electrode may connect circuit pattern layers disposed on different layers.

The first through electrode connects circuit pattern layers arranged in different layers and may function as a heat transfer path between the circuit pattern layers.

The second through electrode may function to electrically connect circuit pattern layers arranged in different layers to each other and transmit electrical signals accordingly.

For example, the first through electrode may be referred to as a 'heat dissipation electrode part' that transmits heat, and the second through electrode may be referred to as a 'signal electrode part' that transmits electrical signals.

However, the embodiment is not limited to this, and the first through electrode may be electrically and physically separated from the second through electrode, and may perform other functions (for example, a ground function) other than the heat transfer function.

The second through electrode will be preferentially described.

The second through electrode may be disposed in a through hole passing through the first insulating layer 110, the second insulating layer 120, and the third insulating layer 130, respectively.

The second through electrode may include a second-first through electrode V1 disposed in the first insulating layer 110. The second-first through electrode V1 may electrically connect the first circuit pattern layer 141 disposed on the upper surface of the first insulating layer 110 and the second circuit pattern layer 142 disposed on the lower surface of the first insulating layer 110.

The second through electrode may include a second-second through electrode disposed on the second insulating layer 120. For example, in a case of the structure of FIG. 1A, the second-second through electrodes V2, V3, and V4 may be respectively disposed in a plurality of second insulating layers 120. Additionally, in a case of a structure of FIG. 1B, the second-second through electrode V2 may be disposed in one second insulating layer 120. The second-second through electrode V2, V3 and V4 may electrically connect the first circuit pattern layer 141 and the third circuit pattern layer 143, 144, and 145.

The second through electrode may include a second-third through electrode disposed in the third insulating layer 130. For example, in the case of the structure of FIG. 1A, the second-third through electrodes V5, V6, and V7 may each be disposed in a plurality of third insulating layers 130. Additionally, in the case of the structure of FIG. 1B, the second-third through electrode V5 may be disposed in one second insulating layer 120. The second-third through electrodes V5, V6, and V7 may electrically connect the second circuit pattern layer 142 and the fourth circuit pattern layer 146, 147, and 148.

Meanwhile, in FIGS. 1A and 1B, one second through electrode is shown as being disposed in a through hole penetrating only one insulating layer, but the present invention is not limited thereto. For example, one second through electrode may be disposed in a through hole that commonly passes through a plurality of insulating layers.

Meanwhile, a first through electrode H1 may be formed in at least one of the first insulating layer 110, the second insulating layer 120, and the third insulating layer 130. Preferably, a first through electrode H1 may be formed in an insulating layer adjacent to the first-first pattern part 141b while vertically overlapping the first-first pattern part 141b. Preferably, a first through electrode H1 may be passed through the first insulating layer 110. The first through electrode H1 is not physically and electrically connected to the second through electrodes V1, V2, V3, V4, V5, V6, and V7 that are the signal electrode parts. Here, the meaning of not being physically connected above may mean that the first through electrode H1 and the second through electrode V1, V2, V3, V4, V5, V6, and V7 are not directly connected to each other through at least one of the circuit pattern layers or through electrodes other than the insulating layers of the embodiment.

Preferably, the first through electrode H1 may be formed on the first insulating layer 110, and one surface thereof may be connected to the first circuit pattern layer 141, and the other surface thereof may be connected to the second circuit pattern layer 142.

Specifically, the second circuit pattern layer 142 includes a second-first pattern part 142a and a second-second pattern part 142b. In addition, the second-first pattern part 142a of the second circuit pattern layer 142 may refer to a signal wiring connected to the second through electrode V1, V2, V3, V4, V5, V6, and V7, the first-second pattern part 141a, and the first-third pattern part 141c. In addition, the second-second pattern part 142b may be a heat dissipation pattern or a dummy pattern that is not electrically connected to the second through electrode V1, V2, V3, V4, V5, V6, and V7, the first-second pattern part 141a, and the first-third pattern part 141c.

An upper surface of the first through electrode H1 may be connected to the first-first pattern part 141b of the first circuit pattern layer 141. A lower surface of the first through electrode H1 may be connected to the second-second pattern part 142b of the second circuit pattern layer 142. Accordingly, the first through electrode H1 may transfer heat transferred from the cavity 160 to the first-first pattern part 141b to the second-second pattern part 142b of the second circuit pattern layer 142.

The first through electrode H1 may be formed together with the second through electrode V1, V2, V3, V4, V5, V6, and V7 rather than through a separate process from the second through electrode V1, V2, V3, V4, V5, V6, and V7. Accordingly, the first through electrode H1 may have the same shape as the second through electrode V1, V2, V3, V4, V5, V6, and V7.

An embodiment includes a first through electrode H1 connected to the first-first pattern part 141b of the first circuit pattern layer 141, and heat generated from the chip disposed in the cavity 160 may be easily transferred to another layer of the circuit board by using the first through electrode H1, thereby improving heat dissipation characteristics of the circuit board. Also, an embodiment may improve the operation characteristics of the chip as the heat dissipation characteristics of the circuit board are improved, and further, product reliability may be improved.

Meanwhile, the first through electrode H1 and the second through electrode V1, V2, V3, V4, V5, V6, and V7 may be formed by filling the inside of a through hole (not shown) passing through at least one insulating layer among the plurality of insulating layers with a conductive material.

The through hole may be formed by any one of mechanical, laser, and chemical processing method. When the via hole is formed by mechanical processing, a method such as milling, drilling and routing may be used, when the via hole is formed by laser processing, a method of UV or CO₂ laser may be used, and when the via hole is formed by chemical processing, a chemical including aminosilane, ketone, or the like may be used, and accordingly, at least one insulating layer among the plurality of insulating layers may be opened.

Meanwhile, the laser processing is a cutting method in which a part of a material is melted and evaporated by concentrating optical energy at a surface to take a desired shape. Complex formation by a computer program may be easily processed, and composite materials which are difficult to cut by other methods may be processed.

In addition, the processing by the laser may have a cutting diameter of at least 0.005 mm, and has a wide range of thickness that may be processed.

The embodiment may use an yttrium aluminum garnet (YAG) laser or CO₂ laser or ultraviolet (UV) laser as the laser processing drill. The YAG laser is a laser capable of processing both a copper foil layer and an insulating layer, and the CO₂ laser is a laser capable of processing only an insulating layer.

When the through hole is formed, the first through electrode H1 and the second through electrode V1, V2, V3, V4, V5, V6, and V7 may be formed by filling an inside of the through hole with a conductive material. The metal material forming the first through electrode H1 and the second through electrode V1, V2, V3, V4, V5, V6, and V7 may be any one material selected from among copper (Cu), silver (Ag), tin (Sn), gold (Au), nickel (Ni), and palladium (Pd), and the conductive material filling may use any one or a combination of electroless plating, electrolytic plating, screen printing, sputtering, evaporation, ink-jetting and dispensing.

Meanwhile, the circuit board may include protective layers 151 and 152 disposed on an outermost side.

For example, the first protective layer 151 may be disposed on the upper surface of the second insulating layer 120 disposed at an uppermost portion among the plurality of insulating layers. For example, a first protective layer 151 may be disposed on an upper surface of the second-third insulating layer 123 disposed at an uppermost portion of the second insulating layer 120.

Additionally, a second protective layer 152 may be disposed on a lower surface of the third insulating layer 130 disposed at a lowest portion among the plurality of insulating layers. For example, the second protective layer 152 may be disposed on a lower surface of the third-third insulating layer 133 disposed at a lowest portion of the plurality of third insulating layers 130.

The first protective layer 151 and the second protective layer 152 may each have an opening. For example, the first protective layer 151 may include an opening (not shown) vertically overlapping at least one of the third circuit pattern layers disposed at an outermost side.

In addition, the second protective layer 152 may include an opening (not shown) vertically overlapping at least one of the fourth circuit pattern layers disposed at an outermost side.

The first protective layer 151 may include an opening (not shown) vertically overlapping the cavity 160 formed in the second insulating layer 120. A width of the opening of the first protective layer 151 may not change at an entire region. Alternatively, the opening of the first protective layer 151 may include at least one region of which the width is changed. Also, at least a portion of the region of which the width of the opening is changed may be equal to a width of at least one region of the cavity 160. For example, an upper surface of the second insulating layer 120 adjacent to the cavity 160 may be covered with the first protective layer 151. Accordingly, in an embodiment, a dead region provided when a portion of the upper surface of the second insulating layer adjacent to the cavity 160 is not covered with the first protective layer 151 may be removed.

Meanwhile, the first protective layer 151 and the second protective layer 152 may include an insulating material. The first protective layer 151 and the second protective layer 152 are provided to protect the surfaces of the circuit patterns, and accordingly, they may include various materials that may be cured by heating after being applied. The first protective layer 151 and the second protective layer 152 may be resist layers. For example, the first protective layer 151 and the second protective layer 152 may be solder resist layers including an organic polymer material. For example, the first protective layer 151 and the second protective layer 152 may include an epoxy acrylate-based resin. Specifically, the first protective layer 151 and the second protective layer 152 may include a resin, a curing agent, a photo initiator, a pigment, a solvent, a filler, an additive, an acrylic-based monomer, and the like. However, the embodiment is not limited thereto, and the first protective layer 151 and the second protective layer 152 may be any one of a photo-solder resist layer, a cover-lay, and a polymer material.

The first protective layer 151 and the second protective layer 152 may have a thickness of about 1 µm to about 20 µm. The first protective layer 151 and the second protective layer 152 may have a thickness of about 1 µm to about 15 µm. For example, the first protective layer 151 and the second protective layer 152 may have a thickness of about 5 µm to about 20 µm. When the thicknesses of the first protective layer 151 and the second protective layer 152 are greater than about 20 µm, the thickness of the circuit board 100 may be increased. When the thicknesses of the first protective layer 151 and the second protective layer 152 are less than about 1 µm, reliability of circuit pattern layers included in the circuit board 100 may be deteriorated.

Hereinafter, the cavity 160 formed in the second insulating layer 120 will be described in detail.

A cavity 160 may be formed in the second insulating layer 120. In this case, the cavity 160 may commonly pass through a plurality of second insulating layers 120 or may pass through a single second insulating layer.

That is, in the circuit board having the structure of FIG. 1A, the cavity 160 may be formed to pass through the second-first insulating layer 121, the second-second insulating layer 122, and the second-third insulating layer 123. Also, in the circuit board having the structure of FIG. 1B, the cavity 160 may be formed to pass through one second insulating layer 120.

The cavity 160 according to the structure of FIG. 1A will be described first.

The cavity 160 is provided to pass through the second-first insulating layer 121, the second-second insulating layer 122, and the second-third insulating layer 123. Accordingly, a first upper surface region of the first insulating layer 110 in a region vertically overlapping the cavity 160 may not be covered by the second insulating layer 120.

The cavity 160 may include a first part passing through the second-first insulating layer 121, a second part passing through the second-second insulating layer 122, and a third part passing through the second-third insulating layer 123. Here, as the second insulating layer 122 of an embodiment has a three-layer structure, the cavity 160 is illustrated to include first to third parts, but the embodiment is not limited thereto. For example, when the second insulating layer 120 has a two-layer structure, the cavity 160 may include only first and second parts. For example, when the second insulating layer 120 has a five-layer structure, the cavity 160 may include first to fifth parts passing through each of the insulating layers of the five-layer structure.

The second-first insulating layer 121 may have a first thickness T1. In this case, the second-first insulating layer 121 may include an overlapping region vertically overlapping the first circuit pattern layer 141 and a non-overlapping region vertically non-overlapping the first circuit pattern layer 141. In addition, a first thickness T1 of the second-first insulating layer 121 may mean a thickness of the overlapping region. For example, the first thickness T1 of the second-first insulating layer 121 may mean a vertical distance between adjacent circuit pattern layers. For example, the first thickness T1 of the second-first insulating layer 121 may mean a vertical distance between an upper surface of the first circuit pattern layer 141 and a lower surface of the third-first circuit pattern layer 143. Meanwhile, a thickness of the second-first insulating layer 121 in a non-overlapping region that does not overlap the first circuit pattern layer 141 may correspond to a sum of the first thickness T1 and a thickness T3 of the first circuit pattern layer 141.

The second-first insulating layer 121 may have a first thickness T1 of 5 µm to 20 µm. For example, the second-first insulating layer 121 is composed of an RCC, and thus may have a thickness of 5 µm to 20 µm.

Meanwhile, referring to FIGS. 1A and 2A, the cavity 160 of the second insulating layer 120 includes inner walls S1 and S2.

The inner walls S1 and S2 of the cavity 160 may have a specific surface roughness. In this case, in the embodiment, the inner walls S1 and S2 of the cavity 160 may have a specific surface roughness as a laser process for forming the cavity 160 is performed instead of performing an additional process so that the inner walls S1 and S2 of the cavity 160 have a specific surface roughness.

The inner walls S1 and S2 of the cavity 160 may include portions having different slopes. For example, the inner wall of the cavity 160 may include a first inner wall S1 adjacent to the upper surface of the second insulating layer 120 and a second inner wall S2 adjacent to the upper surface of the first insulating layer 110 or the lower surface of the second insulating layer 120. In this case, a slope of the first inner wall S1 may be different from that of the second inner wall S2.

The first inner wall S1 and the second inner wall S2 are formed through a laser process and a de-smear process included in a process of forming the cavity 160, and may have a surface roughness corresponding thereto.

Meanwhile, in an embodiment, the cavity 160 is formed by using a Gaussian beam. In this case, an outermost portion (a portion adjacent to the inner wall) of the cavity 160 is processed by using a center point of the Gaussian beam. That is, the center point of the Gaussian beam generates a laser having a greatest intensity, and thus an inclination angle of the inner wall of the cavity 160 at the outermost portion may be smaller than that of the comparative example.

In other words, the inner wall of the cavity 160 may have a shape in which the first inner wall S1 and the second inner wall are connected to each other from an upper side. The second inner wall S2 of the cavity 160 may be connected to the first-first pattern part 141b of the first circuit pattern layer 141. For example, the second inner wall S2 of the cavity 160 may be connected in an upward direction from a boundary region between the first portion 141b1 and the second portion 141b2 of the first-first pattern part 141b. For example, a lower end of the cavity 160 may be directly connected to an upper surface of the first-first pattern part 141b.

The first inner wall S1 may have a first inclination angle θ1. Also, the second inner wall S2 may have a second inclination angle θ2 different from the first inclination angle θ1.

For example, the second inclination angle θ2 of the second inner wall S2 of the cavity 160 may mean an inclination angle between a virtual straight line connecting one end E1 and the other end E3 of the second inner wall S2 with respect to the reference surface BS. The reference surface BS may be, for example, an upper surface of the first insulating layer 110, but is not limited thereto.

Also, the first inner wall S1 of the cavity 160 may have a first inclination angle θ1. For example, the first inclination angle θ1 of the first inner wall S1 of the cavity 160 may be smaller than the second inclination angle θ2 of the second inner wall S2. The first inclination angle θ1 of the first inner wall S1 may mean an inclination angle between a virtual straight line connecting one end E2 and the other end E1 of the first inner wall S1 and the reference surface BS.

That is, the first inner wall S1 of the inner wall of the cavity 160 is a part processed using the center point of the Gaussian beam, and accordingly, the second inner wall S2 may have a first inclination angle θ1 smaller than the second inclination angle θ2.

The second inclination angle θ2 of the second inner wall S2 of the inner wall of the cavity 160 may have a range of 130 to 160 degrees. Also, the first inclination angle θ1 of the first inner wall S1 of the cavity 160 may have a range of 92 to 130 degrees smaller than the second inclination angle θ2 of the second inner wall S2.

As described above, when forming an outermost portion of cavity 160, the embodiment may form the cavity to have a smaller inclination angle than the comparative example by using the center point of the Gaussian beam, and accordingly, an overall size in a horizontal direction occupied by cavity 160 may be reduced.

In other words, the inner wall of cavity 160 of an embodiment may include an inflection portion. For example, the inner wall of cavity 160 of the embodiment may include an inflection portion E1.

In addition, the cavity 160 of the embodiment may be divided into a first inner wall S1 having a first inclination angle θ1 and a second inner wall S2 having a second inclination angle around the inflection portion E1.

In addition, a height of the inflection portion E1 may be higher than an upper surface of the first circuit pattern layer 141 and lower than an upper surface of the second-first insulating layer 121.

As described above, when forming the cavity 160, the first inner wall S1 of an outermost portion of the cavity 160 has a first inclination angle θ1, and the second inner wall S2 connected to the first inner wall S1 has a second inclination angle θ2.

This may be implemented by processing the outermost portion of cavity 160 using the center point of the Gaussian beam while using the first-first pattern part 141b, which is a part of the first circuit pattern layer 141, as a laser stopper. Accordingly, the embodiment may significantly reduce a space required to form the cavity as the inclination angle of an outermost portion of the cavity 160 is reduced compared to the comparative example.

Accordingly, the cavity 160 of the embodiment may include a first region R1 vertically overlapping the first inner wall S1, a second region R2 vertically overlapping the second inner wall S2, and a third region R3 other than the first region R1 and the second region R2.

Meanwhile, in an embodiment, the first portion 141b1 of the first-first pattern part 141b of the first circuit pattern layer 141 may have a second thickness T2. Also, in an embodiment, remaining circuit pattern layers (e.g., the first-second pattern part 141a, the first-third pattern part 141c, and the second portion 141b2 of the first-first pattern part 141b) of the first circuit pattern layer 141 may have a third thickness T3. The second thickness T2 may be greater than the third thickness T3.

For example, when the circuit board of the embodiment is manufactured by the SAP method, the circuit pattern layers of the circuit board of the embodiment may include a first metal layer and a second metal layer. Also, when the circuit pattern layers of the embodiment are manufactured by the MSAP method of the circuit board of the embodiment, the circuit pattern layers of the embodiment may further include a copper foil layer in addition to the first and second metal layers. Hereinafter, a case in which the circuit pattern layer of the embodiment is manufactured by the SAP method will be described. However, the embodiment is not limited thereto, and each circuit pattern layer may further include a copper foil layer between the first metal layer and the insulating layer in addition to the first and second metal layers described below.

The first circuit pattern layer 141 may include a first metal layer and a second metal layer. For example, the first-first pattern part 141b, the first-second pattern part 141a, and the first-third pattern part 141c of the first circuit pattern layer 141 may include a first metal layer and a second metal layer, respectively.

The first-first pattern part 141b includes a first portion 141b1 and a second portion 141b2. In addition, the first portion 141b1 of the first-first pattern part 141b may include a first metal layer 141b1-1 and a second metal layer 141b1-2. Also, the second portion 141b2 of the first-first pattern part 141b may include a first metal layer 141b2-1 and a second metal layer 141b2-2.

For example, the first-second pattern part 141a may include a first metal layer 141a-1 and a second metal layer 141a-2. The first-third pattern part 141c may include a first metal layer 141c-1 and a second metal layer 141c-2. Also, the second-first through electrode V1 may correspondingly include a first metal layer V1-1 and a second metal layer V1-2.

In this case, the first metal layers of the pattern part of each of the first circuit pattern layers 141 may be a layer substantially corresponding to each other. Also, the second metal layers of the pattern part of each of the first circuit pattern layers 141 may be a layer substantially corresponding to each other.

In this case, the first metal layers 141b1-1, 141b2-1, 141a-1, 141c-1 of the first portion 141b1 of the first-first pattern part 141b, the second portion 141b2 of the first-first pattern part 141b, the first-second pattern part 141a, and the first-third pattern part 141c may have the same thickness. For example, the first metal layers 141b1-1, 141b2-1, 141a-1 and 141c-1 may have the same thickness. For example, the first metal layers 141b1-1, 141b2-1, 141a-1, and 141c-1 may refer to a seed layer for forming the second metal layers 141b1-2, 141b2-2, 141a-2, and 141c-2 by electroplating, for example, a chemically copper plating layer or an electroless plating layer. A thickness of the first metal layers 141b1-1, 141b2-1, 141a-1, 141c-1 may vary according to plating methods. The first metal layers 141b1-1, 141b2-1, 141a-1, and 141c-1 may be a chemically copper plating layer. In addition, the chemical copper plating layer may be divided into heavy copper plating (heavy copper (more than 2 µm), medium copper plating (about 1-2 µm), and light copper plating (about 1 µm or less), according to a plating method. For example, the first metal layers 141b1-1, 141b2-1, 141a-1, and 141c-1 may have a thickness in a range of 0.5 µm to 3.0 µm. For example, the first metal layers 141b1-1, 141b2-1, 141a-1, and 141c-1 may have a thickness in a range of 1.0 µm to 2.5 µm. For example, the first metal layers 141b1-1, 141b2-1, 141a-1, and 141c-1 may have a thickness in a range of 1.2 µm to 2.3 µm.

The second metal layers 141b1-2, 141b2-2, 141a-2, and 141c-2 of the first circuit pattern layer 141 are electroplating layers formed by electroplating the first metal layers 141b1-1, 141b2-1, 141a-1, and 141c-1 as seed layers.

The thicknesses of the second metal layers 141b1-2, 141b2-2, 141a-2, and 141c-2 may satisfy a range of 5 µm to 15 µm. Obviously, the thicknesses of the second metal layers 141b1-2, 141b2-2, 141a-2, and 141c-2 may be determined based on a total thickness of the first circuit pattern layer 141. For example, a thickness T3 of the first circuit pattern layer 141 may have a range of 5.5 µm to 18 µm. For example, the thickness T3 of the first circuit pattern layer 141 may have a range of 6.5 µm to 17 µm. For example, the thickness T3 of the first circuit pattern layer 141 may have a range of 10 µm to 16 µm.

In this case, in the second metal layers 141b1-2, 141b2-2, 141a-2, and 141c-2, the second metal layer 141b1-2 of the first portion 141b1 of the first-second pattern part 141b may be different from the thickness of the second metal layer 141a-2 of the first-second pattern part 141a, the second metal layer 141c-2 of the first-third pattern part 141c, and the second metal layer 141b2-2 of the second portion 141b of the first-first pattern part 141b.

Specifically, the second metal layer 141b1-2 of the first portion 141b1 of the first-first pattern part 141b may have a thickness greater than the thickness of the second metal layer 141a-2 of the first-second pattern part 141a, the second metal layer 141c-2 of the first-third pattern part 141c, and the second metal layer 141b2-2 of the second portion 141b2 of the first-first pattern part 141b.

That is, the second metal layer 141b1-2 of the first portion 141b1 of the first-first pattern part 141b may be a part in which etching is not performed due to exposure to an etching solution in an etching process of the first metal layers 141a-1, 141c-1, 141b1-1, and 141b2-1. Alternatively, the second metal layer 141a-2 of the first-second pattern part 141a, the second metal layer 141c-2 of the first-third pattern part 141c, and the second metal layer 141b2-2 of the second portion 141b2 of the first-first pattern part 141b is a part where the etching solution is exposed at least once in the etching process of the first metal layers 141a-1, 141c-1, 141b1-1, and 141b2-1 and the etching is performed accordingly.

The thickness of the second metal layer 141b1-2 of the first portion 141b1 of the first-first pattern part 141b may be as great as the etching thickness of the first metal layer 141b1-1, 141b2-1, 141a-1 and 141c-1, compared to the thickness of the second metal layer 141a-2 of the first-second pattern part 141a, the second metal layer 141c-2 of the first-third pattern part 141c, and the second metal layer 141b2-2 of the second portion 141b2 of the first-first pattern part 141b. For example, the thickness of the second metal layer 141b1-2 of the first portion 141b1 of the first-first pattern part 141b may be as large as the thickness of the first metal layer 141b1-1, 141b2-1, 141a-1, and 141c-1 compared to the thickness of the second metal layer 141a-2 of the first-second pattern part 141a, the second metal layer 141c-2 of the first-third pattern part 141c, and the second metal layer 141b2-2 of the second portion 141b2 of the first-first pattern part 141b. For example, a difference between the thickness of the second metal layer 141b1-2 of the first portion 141b1 of the first-first pattern part 141b and the thickness of the second metal layer 141b2-2 of the second portion 141b2 of the first-first pattern part 141b may correspond to the thickness of the first metal layer 141b1-1, 141b2-1, 141a-1, and 141c-1.

Accordingly, a thickness T3 of the second portion 141b2 of the first-first pattern part 141b, the first-second pattern part 141a, and the first-third pattern part 141c may satisfy a range of 5.5µm and 18µm. For example, a thickness T3 of the second portion 141b2 of the first-first pattern part 141b, the first-second pattern part 141a, and the first-third pattern part 141c may satisfy a range of 6.5µm and 17µm. For example, a thickness T3 of the second portion 141b2 of the first-first pattern part 141b, the first-second pattern part 141a, and the first-third pattern part 141c may satisfy a range of 10µm and 16µm.

Alternatively, the thickness T2 of the first portion 141b1 of the first-first pattern part 141b may be greater than the thickness T3. For example, the thickness T2 of the first portion 141b1 of the first-first pattern part 141b may be greater than the thickness T3 and may satisfy a range of 6.0 µm to 21 µm. For example, the thickness T2 of the first portion 141b1 of the first-first pattern part 141b may be greater than the thickness T3 and may satisfy a range of 7.5 µm to 19.5 µm. For example, the thickness T2 of the first portion 141b1 of the first-first pattern part 141b may be greater than the thickness T3 and may satisfy a range of 11.2 µm to 18.3 µm.

Meanwhile, the second circuit pattern layer 142 may have a layer structure corresponding to the first-second pattern part 141a or the first-third pattern part 141c of the first circuit pattern layer 141.

For example, the second-first pattern part 142a of the second circuit pattern layer 142 may include a first metal layer 142a-1 and a second metal layer 142a-2. Also, the second-second pattern part 142b of the second circuit pattern layer 142 may also include a first metal layer 142b-1 and a second metal layer 142b-2. And, each of the second-first pattern part 142a and the second-second pattern part 142b of the second circuit pattern layer 142 may have a thickness T3 corresponding to the first-second pattern part 141a and the first-third pattern part 141c.

In addition, each of the third circuit pattern layers may also include a first metal layer and a second metal layer.

For example, the third-first circuit pattern layer 143 may include a first metal layer 143-1 and a second metal layer 143-2. The third-first circuit pattern layer 143 may have the thickness T3.

For example, the third-second circuit pattern layer 144 may include a first metal layer 144-1 and a second metal layer 144-2. The third-second circuit pattern layer 144 may have the thickness T3.

For example, the third-third circuit pattern layer 145 may include a first metal layer 145-1 and a second metal layer 145-2. The third-third circuit pattern layer 145 may have the thickness T3.

Meanwhile, although not illustrated in FIG. 2A, the fourth circuit pattern layers 146, 147, and 148 may also include a first metal layer and a second metal layer, respectively, and may have the thickness T3.

Meanwhile, referring to FIG. 3, although FIG. 2A shows that the first through electrode H1 and the second through electrode H2 have a single layer structure, this is only for convenience of description and may substantially correspond to the layer structure of the circuit pattern layers. As an example, the description will be based on the first through electrode H1.

Referring to FIG. 3, the first through electrode H1 may include a first metal layer H1-1 corresponding to the first metal layers 141a-1, 141c-1, 141b1-1, and 141b2-1 of the first circuit pattern layers 141. The first metal layer H1-1 of the first through electrode H1 may be formed on an inner wall of the through hole penetrating the first insulating layer 110. Also, the first through electrode H1 may include a second metal layer H1-2 corresponding to the second metal layers 141a-2, 141c-2, 141b1-2, and 141b2-2 of the first circuit pattern layers 141. The second metal layer H1-2 of the first through electrode H1 may be formed on the first metal layer H1-1 to fill the inside of the through hole.

Meanwhile, as shown in FIGS. 1B and 2B, the cavity 160 may be formed in a single-layered second insulating layer 120. Accordingly, the cavity 160 may include only one part passing through the second insulating layer 120.

In this case, FIGS. 1B and 2B differ substantially in the number of layers of the second insulating layer 120 and the third insulating layer 130 and the number of layers of the circuit board compared to FIGS. 1A and 2A, and basic structural features may be the same. For example, the shape of the cavity 160 and the stepped structure of the first-first pattern part 141b illustrated in FIGS. 1B and 2B may be substantially the same as the features described in FIGS. 1A and 2A, and thus a detailed description thereof will be omitted.

On the other hand, the first and second inner walls S1 and S2 of the inner wall of the cavity 160 of the embodiment may have different ratios (e.g., length in the horizontal direction) due to a moving pitch of the laser beam during cavity processing, and a length ratio of the first and second inner walls S1 and S2 can be adjusted to 1:9 to 9:1 by adjusting the moving pitch of the laser beam.

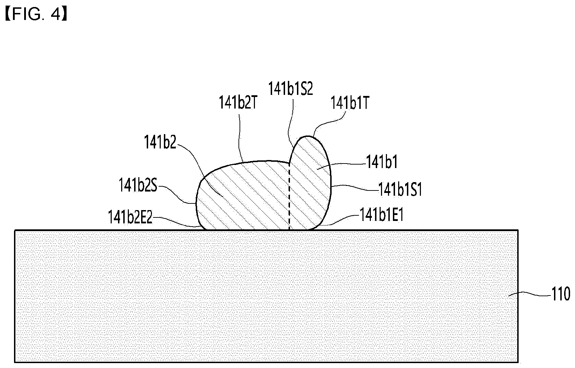

FIG. 4 is a view showing a shape of a first-first pattern part according to an embodiment in more detail.

Referring to FIG. 4, the first-first pattern part 141b includes a first portion 141b1 and a second portion 141b2.

The first portion 141b1 of the first-first pattern part 141b may include a first side surface 141b1S1, an upper surface 141b1T, and a second side surface 141b1S2.

The first side surface 141b1S1 of the first portion 141b of the first-first pattern part 141b does not vertically overlap the cavity 160, and thus refers to a portion covered with the second insulating layer 120. At this time, the first side surface 141b1S1 of the first portion 141b1 of the first-first pattern part 141b may include a curved surface that is convex outward. At this time, a concave portion may be formed at a lower end portion 141b1E1 of the first side surface 141b1S1 of the first portion 141b1 of the first-first pattern part 141b, and the concave portion may be provided concave in an inward direction. That is, the first portion (141b1, specifically the second metal layer of the first portion) of the first-first pattern part 141b is not exposed to the etching solution during the etching process of the seed layer, and a portion of the first metal layer 141b1-1 of the first portion 141b1 may be removed together when the seed layer is etched. Through this, a concave portion can be formed in the lower end portion 141b1E1 of the first side surface 141b1S1 of the first portion 141b1 of the first-first pattern part 141b, and the concave portion may be filled with a second insulating layer 120. Through this, the embodiment can improve the adhesion between the second insulating layer 120 and the first-first pattern part 141b by filling the concave portion with the second insulating layer 120. Accordingly, the embodiment can improve the electrical reliability and physical reliability of the circuit board accordingly.

Meanwhile, the upper surface 141b1T and the second side surface 141b1S1 of the first portion 141b1 of the first-first pattern part 141b may have a certain slope or curve. For example, at least a portion of the upper surface 141b1T and the second side surface 141b1S2 of the first portion 141b1 of the first-first pattern part 141b may include a curved surface. Accordingly, the thickness of the first portion 141b1 of the first-first pattern part 141b may vary depending on the location. In addition, the thickness T2 of the first portion 141b1 of the first-first pattern part 141b may be an average value of the thickness of an entire region of the first portion 141b1, or may mean a thickness of a region with a greatest thickness among the entire region of the first portion 141b1.

In addition, the second portion 141b2 of the first-first pattern part 141b may include an upper surface 141b2T and a side surface 141b2S. In addition, the upper surface 141b2T and the side surface 141b2S of the second portion 141b2 of the first-first pattern part 141b may each have a curve or include a region having a curved surface. Accordingly, the thickness T3 of the second portion 141b2 of the first-first pattern part 141b may mean an average value of the thickness of the entire region of the second portion 141b2, or may refer to a thickness of a region with a greatest thickness among the entire region of the second portion 141b2. Meanwhile, a concave portion depressed inward may be formed in the lower end portion 141b2E2 of the side surface 141b2S of the first-first pattern part 141b.

Hereinafter, the first through electrode H1 according to the embodiment will be further described.

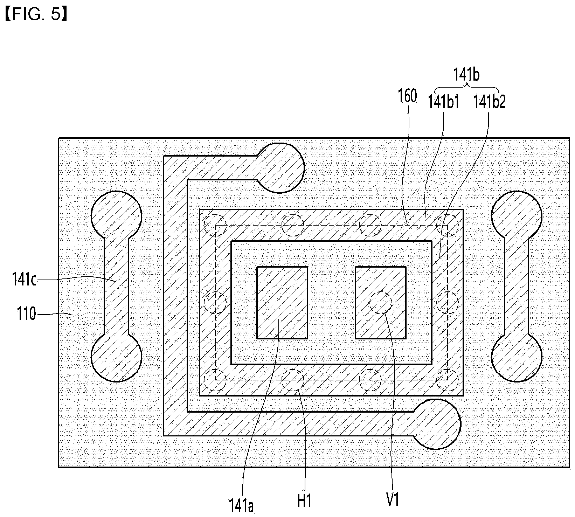

FIG. 5 is a plan view of an upper surface of a first insulating layer 110 according to one embodiment.

A first circuit pattern layer 141 is disposed on the upper surface of the first insulating layer 110.

At this time, the first circuit pattern layer 141 includes a first-second pattern part 141a in the first upper surface region vertically overlapping the cavity 160. The first-second pattern part 141a does not vertically overlap the inner wall of the cavity. That is, the first-second pattern part 141a may be horizontally spaced apart from the first-first pattern part 141b and may be disposed inside the boundary region.

Additionally, the first circuit pattern layer 141 includes a first-third pattern part 141c disposed in the second upper surface region vertically overlapping the second insulating layer 120, without vertically overlapping the cavity 160 and the inner wall of the cavity 160. Additionally, the first circuit pattern layer 141 may include a first-first pattern part 141b formed in a boundary region between the first upper surface region and the second upper surface region.

At this time, the first-first pattern part 141b may have a square closed loop shape formed surrounding the boundary region. However, the embodiment is not limited thereto, and the first-first pattern part 141b may have a circular shape, a triangular shape, or a polygonal shape, and may also have an open loop shape open on at least one side.

Meanwhile, a first through electrode H1 is disposed in the first insulating layer 110 and vertically overlaps the first-first pattern part 141b. At this time, the first through electrode H1 may be formed in plural numbers and spaced apart from each other in the horizontal direction. For example, as shown in FIG. 5, the number of first through electrodes H1 may be 10, but the number is not limited thereto. Accordingly, the embodiment can branch and transfer the heat transferred to the first-first pattern part 141b to a plurality of first through electrodes H1 spaced apart from each other, thereby further improving heat transfer characteristics.

On the other hand, the first through electrode H1 may have a structure in which at least a part of the first through electrode H1 vertically overlaps the cavity 160, and at least a part of the remaining part vertically overlaps the second insulating layer 120 without vertically overlapping the cavity 160.

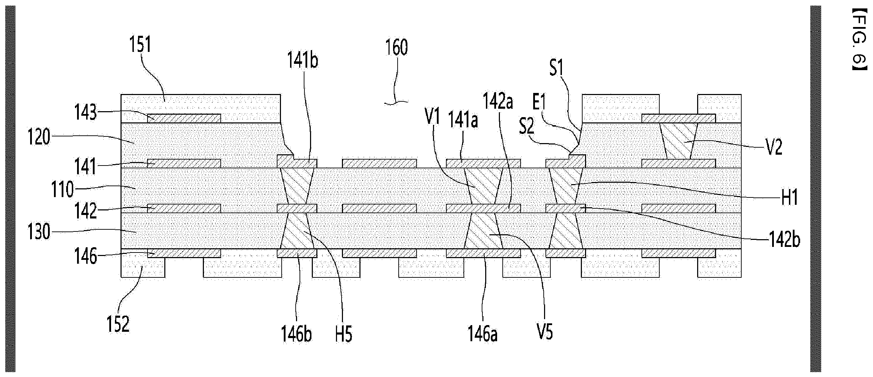

FIG. 6 is a view showing a circuit board according to a second embodiment.

Referring to FIG. 6, the circuit board according to the second embodiment is substantially the same as the circuit board shown in FIG. 1B, but differs in the structure of the first through electrode. The explanation will be based on differences from the previous embodiment while omitting the explanation of the previously explained parts.

The first through electrode H1 according to the previous embodiment is formed only in the first insulating layer 110. For example, the first through electrode formed on the first insulating layer 110 may be referred to as a first-first through electrode.

Alternatively, the first through electrode of the second embodiment may be formed in a plurality of insulating layers and thus may be interconnected.

Specifically, the first through electrode of the previous embodiment has a structure formed only in the first insulating layer 110 while being connected to the first-first pattern part 141b.

Alternatively, the first through electrode of the second embodiment may be formed in a plurality of insulating layers.

For example, the first through electrode may include a first-first through electrode H1 formed in the first insulating layer 110 and connected to a first-first pattern part 141b of the first circuit pattern layer 141. In this case, as shown in FIG. 5, a plurality of first-first through electrodes H1 may be formed to be spaced apart from each other in a horizontal direction.

Meanwhile, the first through electrode may include a first-second through electrode H5 formed in the third insulating layer 130. The first-second through electrode H5 is formed in the third insulating layer 130 and, thus, may be connected to the first-first through electrode H1.

For example, an upper surface of the first-second through electrode H5 may be connected to a second-second pattern part 142b of the second circuit pattern layer 142 connected to the first-first through electrode H1.

Meanwhile, the third circuit pattern layer 146 of the embodiment may include a third-first pattern part 146a and a third-second pattern part 146b. The third-first pattern part 146a may refer to a signal line connected to the second-third through electrode V5. The third-second pattern part 146b is connected to the second-second through electrode H5, corresponding to the second-second pattern part 142b of the second circuit pattern layer 142, and therefore, the third-second pattern part 146b may function as a heat dissipation pad that transfers heat to the outside.

For example, a lower surface of the first-second through electrode H5 is connected to the third-second pattern part 146b of the third circuit pattern layer 146. In this case, the third-second pattern part 146b of the third circuit pattern layer 146 may mean a circuit pattern layer disposed at a lowermost side of the circuit board.

In addition, the second protective layer 152 of the embodiment may include at least one opening (not shown) vertically overlapping the third-second pattern part 146b.

Accordingly, the embodiment may radiate heat generated in the cavity 160 to the outside of the circuit board through the third-second pattern part 146b.

Specifically, the heat generated in the cavity 160 (specifically, the heat generated by a chip mounted in the cavity) is transferred to the first-first pattern part 141b of the first circuit pattern layer 141.

In addition, the heat transferred to the first-first pattern part 141b may be emitted to the outside of the circuit board (clearly, a lowermost side of the circuit board) through the first-first through electrode H1, the second-second pattern part 142b, the first-second through electrode H5, and the third-second pattern part 146b.

Therefore, the embodiment allows the first through electrode to be disposed in each of the plurality of insulating layers as described above. Accordingly, the embodiment may easily discharge heat generated from the chip mounted in the cavity 160 to the outermost side of the circuit board by using the first through electrode, thereby improving the overall heat dissipation characteristics of the circuit board.

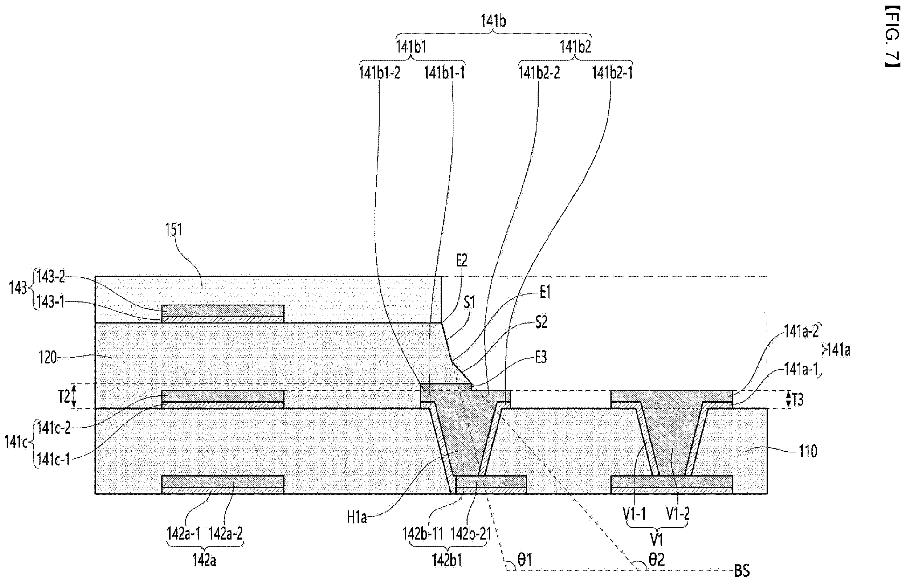

FIG. 7 is a view showing a modified example of a first through electrode according to an embodiment.

Referring to FIG. 7, at least a portion of the first through electrode H1 may contact an upper surface of the third insulating layer 130.

That is, the first through electrode of the previous embodiment contacts only the upper surface of the second-second pattern part 142b of the second circuit pattern layer 142. This is because the second-second pattern part 142b of the second circuit pattern layer 142 and the first through electrode have a structure in which they are aligned in the vertical direction.

However, the first through electrode functions differently from the second through electrode. That is, the first through electrode is not an electrode for signal transmission, but a heat dissipation electrode for heat transfer. Accordingly, the first through electrode may have a structure that is not aligned with the second-second pattern part 142b of the second circuit pattern layer 142.

For example, the first through electrode H1a passes through the first insulating layer 110. At this time, at least a portion of a lower surface of the first through electrode H1a may be located lower than an upper surface of the second circuit pattern layer 142.

For example, the lower surface of the first through electrode H1a may have a step. That is, the lower surface of the first through electrode H1a may include a first lower surface region in contact with the second-second pattern part 142b of the second circuit pattern layer 142, and a second lower surface region positioned lower than the first lower surface region and extending in a downward direction while covering a side surface of the second-second pattern part 142b. Through this, the embodiment can increase a size of the first through electrode H1a within an allowed space regardless of the size of the second-second pattern part 142b, and accordingly, heat dissipation characteristics can be further improved.

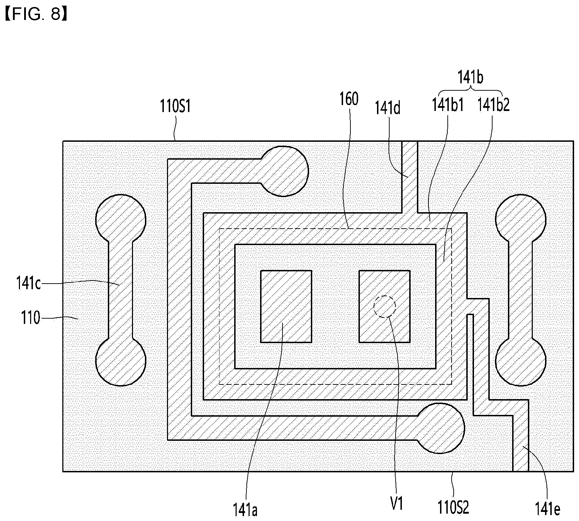

FIG. 8 is a view showing a first circuit pattern layer of a circuit board according to another embodiment

FIG. 8 is a top plan view of an upper region of the first insulating layer 110 in a state in which the second insulating layer 120 is removed.

Referring to FIG. 8, the circuit board of another embodiment may not include the first through electrode described above.

For example, the circuit board may discharge heat generated in the cavity 160 in a horizontal direction in a layer where the first-first pattern part 141b is disposed, rather than dissipating heat generated in the cavity 160 in a vertical direction through the first through electrode.

To this end, the first circuit pattern layer 142 may include a first-fourth pattern part 141d and a first-fifth pattern part 141e. The first-fourth pattern part 141d and first-fifth pattern part 141e may also be referred to as an extension pattern part.

The first-fourth pattern part 141d and the first-fifth pattern part 141e may be disposed in the second upper surface region of the first insulating layer 110.

However, the first-fourth pattern part 141d and the first-fifth pattern part 141e may be electrically separated (e.g., insulated) from the first-third pattern part 141c.

That is, the first-fourth pattern part 141d and the first-fifth pattern part 141e may be disposed while avoiding a region in which the first-third pattern part 141c is disposed among the second upper surface regions of the first insulating layer 110.

One end of each of the first-fourth pattern part 141d and the first-fifth pattern part 141e may directly contact one side surface of the first-first pattern part 141b. For example, the first-fourth pattern part 141d and the first-fifth pattern part 141e may be extension pattern parts extending horizontally from the first-first pattern part 141b.

In this case, the embodiment may include only one of the first-fourth pattern part 141d and the first-fifth pattern part 141e, but both the first-fourth pattern part 141d and the first-fifth pattern part 141e may be included to improve heat dissipation characteristics.

One end of the first-fourth pattern part 141d may be connected to a first side surface of the first-first pattern part 141b. Additionally, the first-fourth pattern part 141d may extend toward an outer side surface of the circuit board. Accordingly, the other end of the first-fourth pattern part 141d may be exposed to a first outer side surface of the circuit board, clearly a first outer side surface 110S1 of the first insulating layer 110. The first-fourth pattern part 141d may function as a first heat transfer path that radiates heat transferred from the first-first pattern part 141b to the first outer side surface 110S1.

Meanwhile, one end of the first-fifth pattern part 141e may be connected to a second side surface different from the first side surface of the first-first pattern part 141b. Additionally, the other end of the first-fifth pattern part 141e may extend toward the outer side surface of the circuit board. Accordingly, the other end of the first-fifth pattern part 141e may be exposed to a second outer side surface 110S2 of the circuit board, clearly the second outer side surface 110S2 of the first insulating layer 110. At this time, the first outer side surface 110S1 of the first insulating layer 110 to which the first-fourth pattern part 141d extends and the second outer side surface 110S2 of the first insulating layer 110 to which the first-fifth pattern part 141e extends, may be different outer side surfaces among a plurality of outer side surfaces of the first insulating layer 110. Preferably, the first outer side surface 110S1 and the second outer side surface 110S2 may be opposite side surfaces to each other. The first-fifth pattern part 141e may function as a second heat transfer path that radiates heat transferred from the first-first pattern part 141b to the second external side surface 110S2.

As described above, the embodiment may radiate heat generated in the cavity 160 to the outside through a heat transfer path in a horizontal direction rather than a heat transfer path in a vertical direction using at least one of the first-fourth pattern part 141d and the first-fifth pattern part 141e.

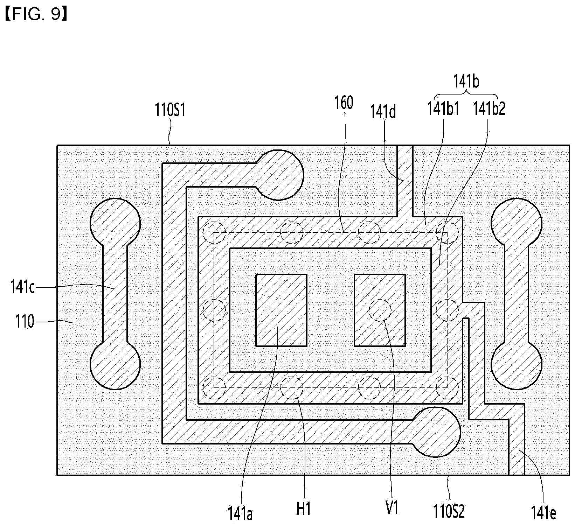

FIG. 9 is a view showing a modified example of a circuit board according to an embodiment.

Referring to FIG. 9, the circuit board of the embodiment may include not only the first through electrode, but also the first-fourth pattern part 141d and the first-fifth pattern part 141e.

That is, in the embodiment, heat generated in the cavity 160 may be radiated to the outside by a vertical path using the first through electrode, and heat generated in the cavity 160 may be radiated by a horizontal path using the first-fourth pattern part 141d and the first-fifth pattern part 141e.

As described above, the embodiment may further improve heat dissipation characteristics of the circuit board by providing a heat path in a horizontal direction as well as a heat path in a vertical direction, thereby further improving product reliability.

On the other hand, the first-fourth pattern part 141d and the first-fifth pattern part 141e providing a heat transfer path in a horizontal direction are shown to be disposed only on the upper surface of the first insulating layer 110, but are not limited thereto.

For example, at least one of the second circuit pattern layer 142 and the third circuit pattern layer may include at least one pattern part that radiates heat to a heat transfer path in a horizontal direction.

For example, referring to FIG. 1B, the first-first pattern part 141b is connected to a first through electrode H1.

In addition, the first through electrode H1 is connected to the second-second pattern part 142b of the second circuit pattern layer 142.

In this case, the second circuit pattern layer 142 may include a second-third pattern part (not shown) corresponding to at least one of the first-fourth pattern part 141d and the first-fifth pattern part 141e.

For example, the second circuit pattern layer 142 may include a second-third pattern part (not shown) having one end connected to the second-second pattern part 141c and the other end extending outward from the upper surface of the third insulating layer 130.

And, looking at the heat transfer path in the above structure, heat generated in the cavity 160 may be transferred in a vertical direction through the first-first pattern part 141b, the first through electrode H1, and the second-second pattern part 142b. And, heat transferred to the second-second pattern part 142b may be transferred in a horizontal direction through the second-third pattern part (not shown), and thus may be radiated to an outer side surface of the upper surface of the third insulating layer 130.

Hereinafter, a semiconductor package using a circuit board according to an embodiment as a package substrate will be described.

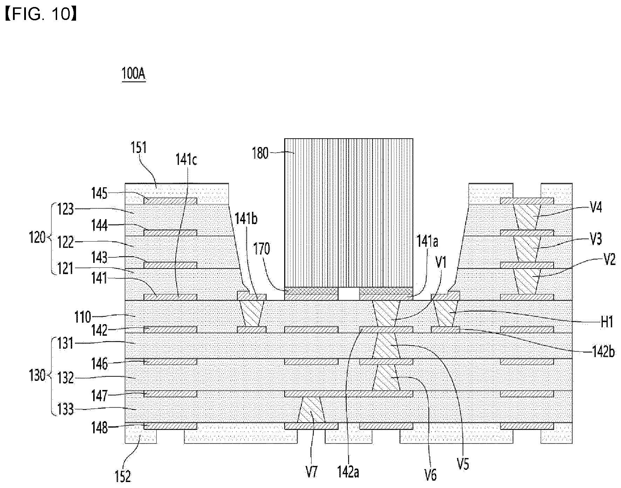

FIG. 10 is a view showing a semiconductor package according to a first embodiment.

Referring to FIG. 10, a semiconductor package 200 according to an embodiment may use the circuit board 100 shown in FIG. 1A as a package substrate. The semiconductor package 200 includes an electronic device 180 mounted in the cavity 160 of the circuit board 100. However, the embodiment is not limited thereto, and the package substrate may be configured as the electronic device is mounted in the cavity of the other circuit board among the circuit boards of various embodiments described above.

That is, the circuit boards described above may be used as package substrates for mounting an electronic device 180 such as a chip.

As described above, the circuit board includes a cavity 160, and at least a portion of a first circuit pattern layer 141 may be disposed in the cavity 160. That is, a first-second pattern part 141a of the first circuit pattern layer 141 and a second portion 141b2 of the first-first pattern part 141b may be disposed in the cavity 160.

A connection part 170 may be disposed on the first-second pattern part 141a.

In this case, a planar shape of the connection part 170 may be a rectangle. The connection part 170 may be disposed on the first-second pattern part 141a to fix the electronic device 180, and may function to electrically connect the electronic device 180 with the first-second pattern part 141a. To this end, the connection part 170 may include a conductive material. For example, the connection part 170 may be a solder ball, but is not limited thereto.

The connection part 170 may contain a material of a different component in solder. The solder may be composed of at least one of Sn-Cu, Sn-Pb, and Sn-Ag-Cu. And, the material of the different component may contain any one of Al, Sb, Bi, Cu, Ni, In, Pb, Ag, Sn, Zn, Ga, Cd, and Fe.

An electronic device 180 may be mounted on the connection part 170.

In this case, the electronic device 180 may be an electronic component disposed in the cavity 160 of the circuit board 100, which may be divided into an active element and a passive element. In addition, the active element is a device actively using a nonlinear part, and the passive element refers to a device that does not use the nonlinear characteristic even though both the linear and the nonlinear characteristics exist. In addition, the passive element may include a transistor, an IC semiconductor chip, and the passive element may include a capacitor, a resistor, an inductor, and the like. The passive element is mounted on a conventional circuit board in order to increase a signal processing speed of a semiconductor chip, which is an active element, or to perform a filtering function.

In this case, an upper surface of the electronic device 180 may be positioned higher than an outermost side of the circuit board. For example, an upper surface of the electronic device 180 may be positioned higher than an upper surface of a first protective layer 151 disposed at an outermost side of the circuit board. However, an embodiment is not limited thereto, and the upper surface of the electronic device may be positioned on the same plane as the outermost surface of the circuit board or may be positioned lower than the outermost surface of the circuit board, depending on the type of electronic device mounted in the cavity 160.

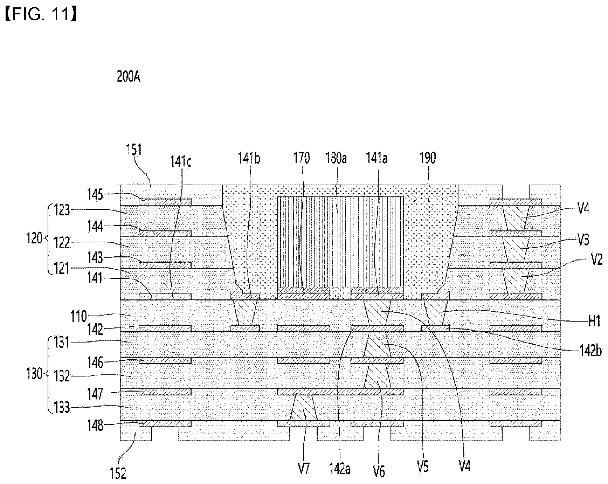

FIG. 11 is a view showing a semiconductor package according to a second embodiment.

Referring to FIG. 11, the semiconductor package 200A of an embodiment includes a circuit board 100 and an electronic device 180a mounted in the cavity 160 of the circuit board 100.

In addition, the semiconductor package 200A further includes a molding layer 190 disposed in the cavity 160 and covering the electronic device 180a.

The molding layer 190 may be selectively disposed in the cavity 160 to protect the electronic device 180a mounted in the cavity 160.

The molding layer 190 may be formed of a molding resin, and may be, for example, an epoxy molding compound (EMC). However, the embodiment is not limited thereto, and the molding layer 190 may be formed of various other molding resins other than EMC.

The molding layer 190 of an embodiment is in contact with the first inner wall S1 and the second inner wall S2 of the cavity 160. In this case, the first inner wall S1 and the second inner wall S2 of the cavity 160 may have different inclination angles based on the inflection portion E1 instead of a single inclination angle. The structure of the cavity 160 may increase a surface area in contact with the molding layer 190, thereby improving a bonding force between the molding layer 190 and the circuit board 100.

Hereinafter, a method of manufacturing a circuit board according to an embodiment will be described with reference to the accompanying drawings.

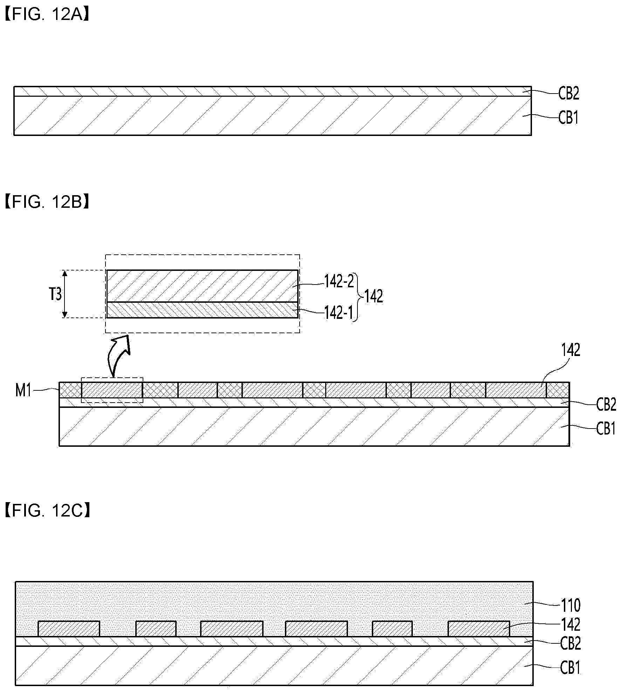

FIGS. 12A to 120 are views showing a method of manufacturing a circuit board method according to an embodiment in order of processes.

Before describing the process of manufacturing the circuit board of the embodiment, the circuit board of the embodiment may have a layer structure of any one of FIGS. 1A and 1B. However, the number of layers of the second insulating layer 120 and the number of layers of the third insulating layer 130 in the circuit board of the embodiment are selectively changed. For example, the number of layers of the second insulating layer 120 may be a single layer, and differently, may have a layer structure of two or more layers. Also, the number of layers of the third insulating layer 130 may be a single layer, and differently, may have a layer structure of two or more layers.

Hereinafter, for convenience of explanation, it will be described that each of the second insulating layer 120 and the third insulating layer 130 is formed of a single layer. However, the embodiment is not limited thereto, at least one of the second insulating layer 120 and the third insulating layer 130 may be formed of a plurality of layers as at least one of the steps of the circuit board manufacturing process described below is performed multiple times.

Meanwhile, hereinafter, it will be described that the circuit board is a coreless substrate. Accordingly, the method of manufacturing a circuit board of the embodiment is manufactured using a carrier board. However, the embodiment is not limited thereto. For example, the circuit board of the embodiment may be a core substrate including a core layer, and accordingly, the carrier board in the manufacturing process may be omitted. In addition, when the circuit board is a core substrate, a position of the second circuit pattern layer 142 disposed on the lower surface of the first insulating layer 110 will not have a structure buried in a lower region of the first insulating layer 110 but a structure protruding below the lower surface of the first insulating layer 110.

Referring to FIG. 12A, an embodiment prepares a base member for manufacturing a circuit board. For example, an embodiment prepares a carrier board for manufacturing a coreless board. For example, an embodiment prepares a carrier board including a carrier insulating layer CB1 and a carrier metal layer CB2. In this case, a stacked structure of the carrier insulating layer CB1 and the carrier metal layer CB2 may be a copper clad laminate (CCL), but is not limited thereto. For example, the carrier metal layer CB2 may be an electroless plating layer formed by performing electroless plating on the carrier insulating layer CB1.

Next, referring to FIG. 12B, in an embodiment, a first dry film M1 is formed on an upper surface of the carrier metal layer CB2. The first dry film M1 may be used as a mask for forming a second circuit pattern layer 142 on the carrier metal layer CB2. To this end, the first dry film M1 may include at least one opening. The opening may vertically overlap a region in which a second circuit pattern layer 142 is to be formed on the upper surface of the carrier metal layer CB2. And, in an embodiment, a process of forming a second circuit pattern layer 142 filling the opening of the first dry film M1 may be performed by performing electroplating on the carrier metal layer CB2 as a seed layer.

In this case, in the embodiment, a separate seed layer may be used for easy separation between the carrier metal layer and the circuit board or for slimming of the second circuit pattern layer 142. For example, in the embodiment, a process of forming the first metal layer 142-1 of the second circuit pattern layer 142 may be performed by performing electroless plating on the carrier metal layer CB2. In addition, the first dry film M1 may be formed on the first metal layer 142-1 with an opening. Additionally, the second circuit pattern layer 142 includes a second metal layer 142-2 formed by electrolytic plating using the first metal layer 142-1 as a seed layer. Accordingly, the second circuit pattern layer 142 may have a two-layer structure including a first metal layer 142-1 and a second metal layer 142-2. In this case, the second circuit pattern layer 142 may include a second-first pattern part 142a and a second-second pattern part 142b.

Next, referring to FIG. 12C, the embodiment may proceed with a process of stacking the first insulating layer 110 on the carrier metal layer CB2.

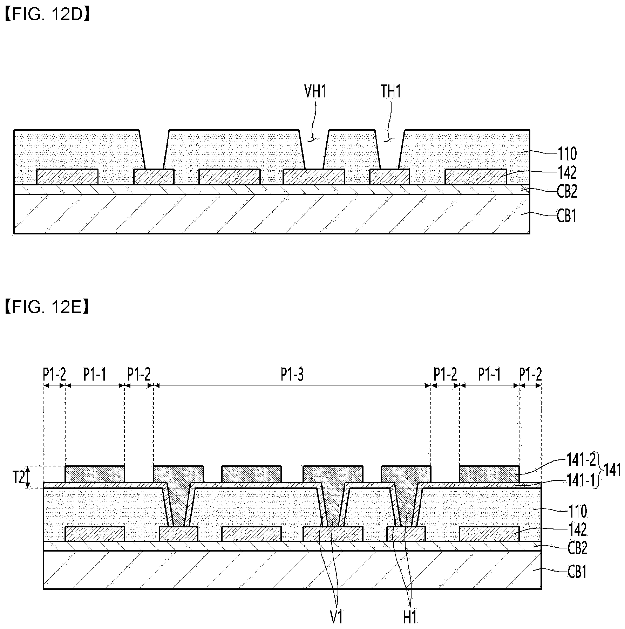

Next, referring to FIG. 12D, the embodiment may proceed with a process of processing the first insulating layer 110 to form a through hole penetrating the first insulating layer 110. In this case, the through hole may include a first through hole TH1 and a second through hole VH1. For example, the second through hole VH1 may vertically overlap the second-first pattern part 142a of the second circuit pattern layer 142. Also, the first through hole TH1 may vertically overlap the second-second pattern part 142b of the second circuit pattern layer 142.

Next, referring to FIG. 12E, an embodiment may proceed with a plating process to form a first through electrode H1 filling the first through hole TH1, a second-first through electrode V1 filling the second through hole VH1, and a first circuit pattern layer 142 disposed on the upper surface of the first insulating layer 110.

In this case, the first circuit pattern layer 141 includes a first metal layer 141-1 and a second metal layer 141-2. Meanwhile, although the first through electrode H1 and the second-first through electrode V1 are shown to have a one-layer structure, the first through electrode H1 and the second-first through electrode V1 may include a first metal layer and a second metal layer corresponding to a layer structure of the first circuit pattern layer 141. Also, although the first metal layer 141-1 of the first circuit pattern layer 141 and the first metal layer of the first through electrode H1 or the second-first through electrode V1 are shown to have a structure distinguished from each other, they may be substantially the same layer. Correspondingly, the second metal layer 141-2 of the first circuit pattern layer 142 and the second metal layer of the first through electrode H1 or the second-first through electrode V1 may also be formed of the same layer.

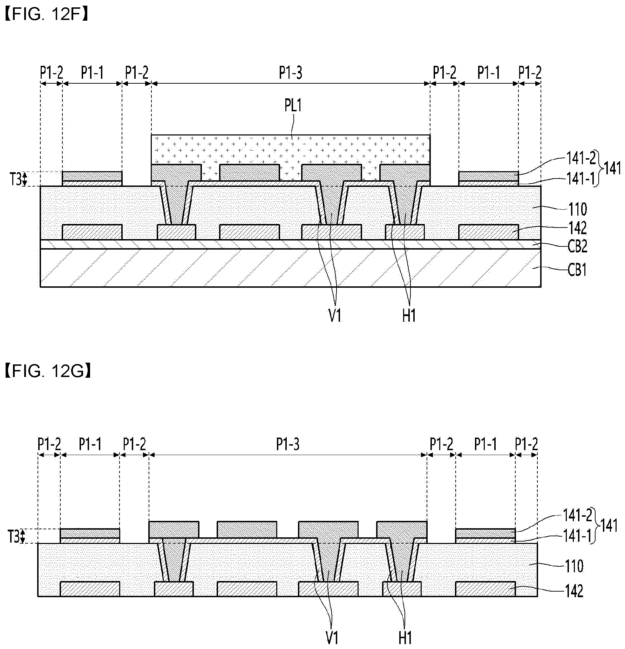

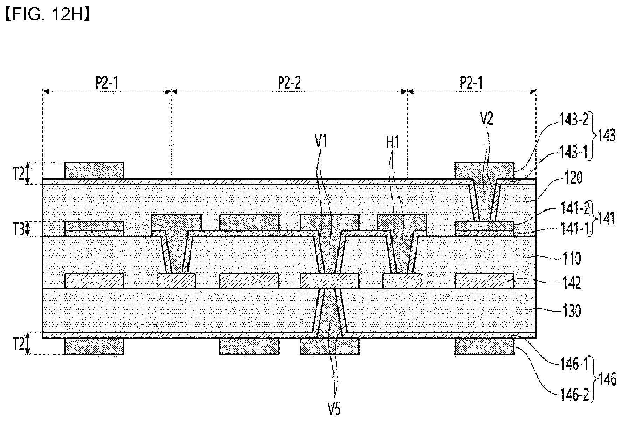

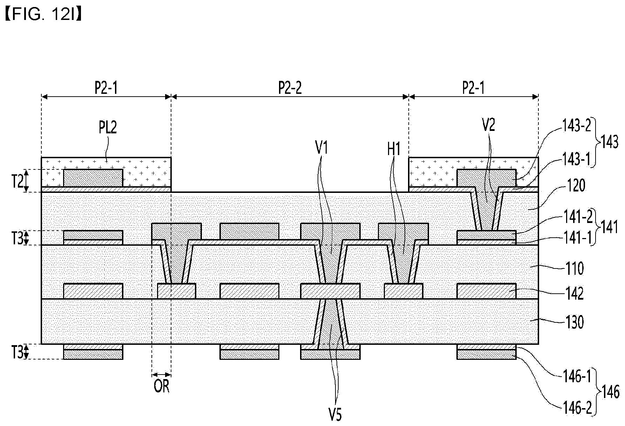

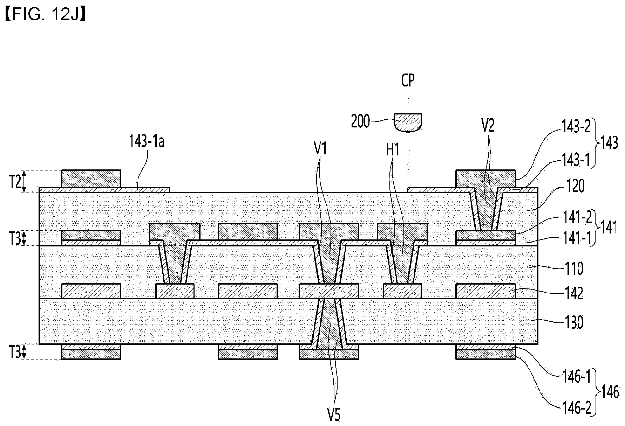

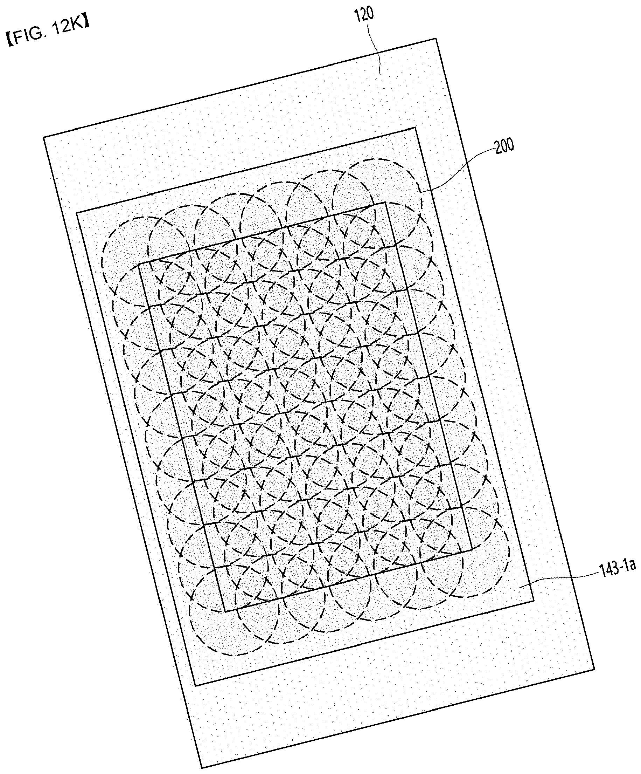

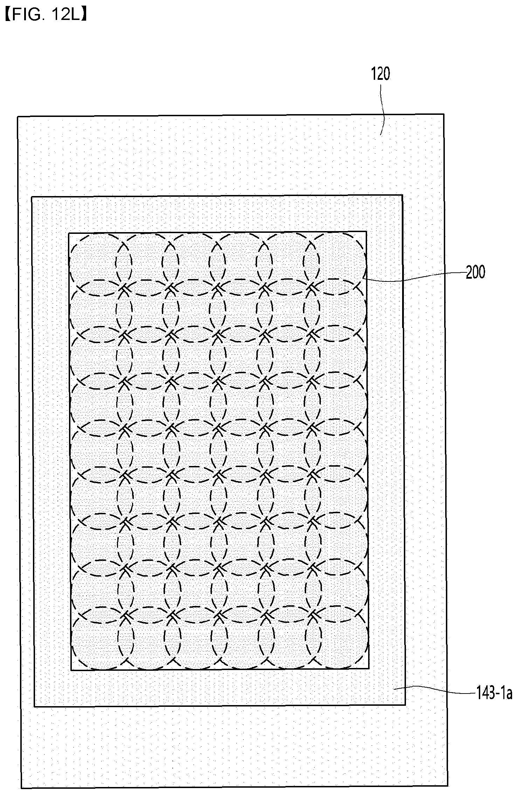

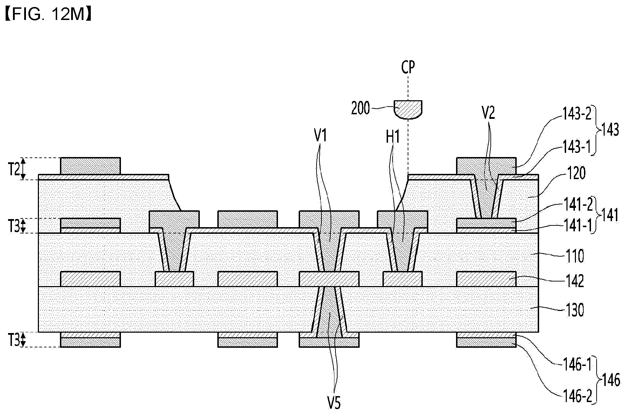

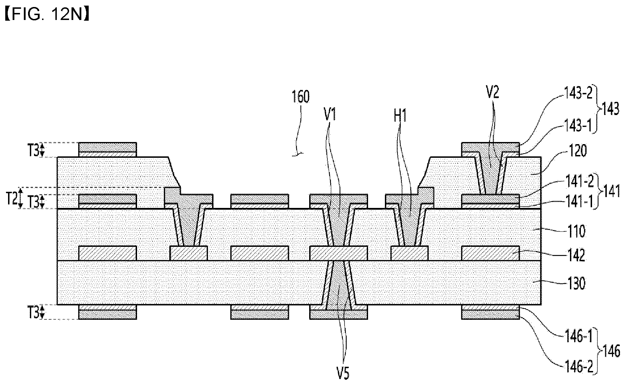

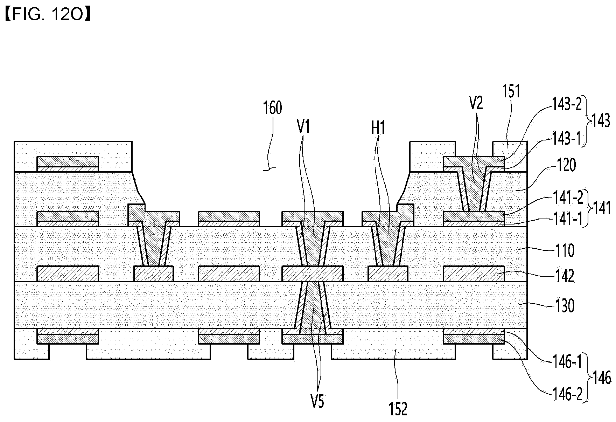

Meanwhile, as shown in FIG. 12, the first circuit pattern layer 141 after the plating process may have a second thickness T2. This is because before the etching process of the first metal layer 141-1 used as the seed layer of the second metal layer 141-2 proceeds.

At this time, in a general circuit board manufacturing process, after the first metal layer 141-1 and the second metal layer 141-2 of the first circuit pattern layer 141 are formed, the first metal layer 141-1 that does not vertically overlap the second metal layer 141-2 is removed by etching.

Here, the embodiment does not remove all of the first metal layer 141-1 that does not vertically overlap the second metal layer 141-2, but at least a portion of the first metal layer remains. And, the first metal layer that remains without being removed above functions as a first mask (e.g., a laser stopper) in a laser process of forming cavity 160 later.

Specifically, the first metal layer 141-1 of the first circuit pattern layer 141 may include a first-first portion P1-1 vertically overlapping the second metal layer 141-2. Also, the first metal layer 141-1 in the first-first portion P1-1 may constitute a portion of the first circuit pattern layer 141.

In addition, the first metal layer 141-1 may include a first-second portion P1-2 that does not vertically overlap the second metal layer 141-2 in a region that does not vertically overlap a cavity region.

In addition, the first metal layer 141-1 may include a first-third portion P1-3 disposed in a region vertically overlapping the cavity region.

In this case, in the comparative example, both the first-second portion P1-2 and the first-third portion P1-3 of the first metal layer 141-1 are removed by etching.

Alternatively, in an embodiment, only the first-second portion P1-2 of the first metal layer 141-1 is removed by etching, and the first-third portion P1-3 of the first metal layer 141-1 is not removed. In addition, the remaining first metal layer 141-1 without being removed in the first-third portion P1-3 may function as a first mask corresponding to a laser stopper in a laser process of forming a cavity later.

Meanwhile, referring to FIG. 12F, in order to selectively remove only the first metal layer 141-1 from the first-second portion P1-2 without removing the first metal layer 141-1 from the first-third portion P1-3, the embodiment may proceed with a process of forming a first protective film PL1 on the first-third portion P1-3. In this case, the first protective film PL1 may be formed on the second metal layer 141-2 of the first-second pattern part 141b and the first-first pattern part 141a as well as on the region in which the first metal layer 141-1 is disposed alone on the first-third portion P1-3.

Next, referring to FIG. 12G, in a state in which the first protective film PL1 is disposed, an etching process of removing the first metal layer 141-1 is performed. Accordingly, the first metal layer 141-1 disposed on the first-second portion P1-2 may be removed. In this case, a part of the second metal layer 141-2 in the first-first portion P1-1 may also be removed in the etching process. For example, the second metal layer 141-2 in the first-first portion P1-1 may be etched by a thickness corresponding to the thickness of the first metal layer 141-1. Accordingly, in an embodiment, the first-third pattern part 141c of the first circuit pattern layer 141 may be formed in the etching process. And, the thickness of the first-third pattern part 141c may be reduced from the second thickness T2 to the third thickness T3 by the etching process.

Next, referring to FIG. 12H, in an embodiment, the second insulating layer 120 is disposed on the first insulating layer 110. Also, in an embodiment, the third insulating layer 130 is disposed under the first insulating layer 110.

In addition, the embodiment may proceed with a process of forming a second-second through electrode V2 of a second through electrode on the second insulating layer 120. In addition, the embodiment may proceed with a process of forming a third circuit pattern layer 143 on the upper surface of the second insulating layer 120. In this case, the third circuit pattern layer 143 may include a first metal layer 143-1 and a second metal layer 143-2 corresponding to the first circuit pattern layer 141.

Furthermore, an embodiment may perform a process of forming a second-third through electrode V5 of a second through electrode on the third insulating layer 130. Furthermore, an embodiment may perform a process of forming a fourth circuit pattern layer 146 on the lower surface of the third insulating layer 130. In this case, the fourth circuit pattern layer 146 may include a first metal layer 146-1 and a second metal layer 146-2.

In this case, an upper region of the third circuit pattern layer 143 may be divided into a plurality of portions. For example, the upper region of the third circuit pattern layer 143 includes a second-first portion P2-1 rather than a cavity region and a second-second portion P2-2 corresponding to the cavity region. In this case, the first metal layer 143-1 in the second-second portion P2-2 should be removed by etching as the laser passes therethrough. Alternatively, the first metal layer 143-1 in the second-first portion P2-1 may not be removed because the first metal layer 143-1 does not vertically overlap the cavity region. In addition, the embodiment remains without removing the first metal layer 143-1 in the second-first portion P2-1, so that it can be used as a second mask in a laser process forming a cavity. In this case, in the embodiment, only the first metal layer 143-1 in the adjacent region surrounding the cavity region may remain in the second-first portion P2-1 and the remaining portion may be removed. However, if etching is performed as described above, the second metal layer 143-2 of the third circuit pattern layer 143 may be additionally etched in the etching process of etching the second stopper later, resulting in a thickness deviation from other circuit pattern layers. Accordingly, the embodiment does not remove all of the first metal layers 143-1 in the second-first portion P2-1 but remains.

Meanwhile, before the etching of the first metal layer 143-1 of the third circuit pattern layer 143 and the first metal layer 146-1 of the fourth circuit pattern layer 146 is performed, each of the third circuit pattern layer 143 and the fourth circuit pattern layer 146 may have a second thickness.

Next, referring to FIG. 12I, in a state in which the second protective film PL2 is disposed on the second-first portion P2-1 of the third circuit pattern layer 143, the embodiment may proceed with an etching process of removing the first metal layer 143-1 of the third circuit pattern layer 143 and the first metal layer 146-1 of the fourth circuit pattern layer 146.

Accordingly, the thickness of the fourth circuit pattern layer 146 may be reduced from the second thickness T2 to the third thickness T3 by the etching process. Alternatively, the etching process is performed while covered by the second protective film PL2, and accordingly, the second metal layer 143-2 of the third circuit pattern layer 143 can maintain the second thickness T2.

Meanwhile, the first metal layer 143-1 of the third circuit pattern layer 143 is disposed in the region adjacent to the cavity region. In this case, the first metal layer 143-1 of the third circuit pattern layer 143 may be larger than a radius of the beam size in a subsequent laser process. That is, in an embodiment, a cavity processing process may be performed to correspond to a center portion of the beam in the Gaussian laser process. Accordingly, a center of the Gaussian beam may be located in the region adjacent to the cavity region. In this case, in an embodiment, as the laser process for the cavity process is performed in a state in which the first metal layer 143-1 in the second-first portion P2-1 is not removed, damage to the surface of the second insulating layer 120 may be prevented even in the process of processing the cavity using the center of the Gaussian beam.

Meanwhile, at least a portion of the first-third portion P1-3 and the second-first portion P2-1 of the embodiment may overlap each other in a vertical direction.

For example, the first circuit pattern layer 141 not removed from the first-third portion P1-3 and the third circuit pattern layer 143 not removed from the second-first portion P2-1 may include overlapping regions OR overlapping in a vertical direction.

At this time, in the comparative example, even if a mask is used during the laser process, the first-third portion P1-3 and the second-first portion P2-1 do not overlap each other in the vertical direction. At this time, if the process accuracy in the laser process is high, it is possible to form a highly reliable cavity even in the arrangement structure of the mask as described above. However, in the circuit board manufacturing process, process deviations due to various environments occur, and accordingly, reliability problems may occur in the mask structure in the comparative example as described above. For example, when the laser beam is distorted due to process deviations, the laser beam can be processed from the lower region of the second insulating layer to the region beyond the first-second portion P1-2 of the first metal layer 141-1. And, in this case, not only the second insulating layer above, but also the first insulating layer as much as the deviated region above may be additionally processed. In addition, when the first insulating layer is processed, reliability problems may occur.

Accordingly, an embodiment includes an overlapping region OR in which the first mask and the second mask overlap each other in the vertical direction as described above. Accordingly, even if a deviation in a laser process occurs, a situation in which the first insulating layer is additionally processed by the overlapping region OR may be prevented, and thus a reliability problem may be solved.

Next, referring to FIG. 12J, the embodiment may proceed with a process of forming the cavity 160 in the cavity region of the second insulating layer 120. In this case, the cavity 160 may be formed in the second insulating layer 120 consisting of a single layer, and differently, may be formed in the second insulating layer 120 consisting of a plurality of layers.

In this case, the cavity 160 may be formed by a laser process using a Gaussian beam.

In this case, in an embodiment, an outermost region of the cavity 160 is formed using a center line CP of the Gaussian beam 200. In this case, referring to FIG. 12J, a beam located on a right with respect to the center line of the Gaussian beam 200 is located within the cavity region, but a beam located on a left is located in a region outside the cavity region.

FIG. 12K is a view for explaining a cavity processing method according to an embodiment, and FIG. 12L is a view for explaining a cavity processing method according to a comparative example.

Referring to FIG. 9, the embodiment processes the outermost region of the cavity 160 using the beam of the center line of the Gaussian beam, based on a part of the third circuit pattern layer 143 used as a second mask 143-1a. Then, the embodiment processes the entire region of the cavity 160 while moving the Gaussian beam by a predetermined distance.

In this case, the embodiment performs processing on the outermost region of the cavity using the center line of a first Gaussian beam. And, when the cavity processing using the first Gaussian beam is completed, a second Gaussian beam is provided at a position spaced apart from the first Gaussian beam by a predetermined distance. In this case, as the first Gaussian beam and the second Gaussian beam are separated by a predetermined distance, the cavity 160 of the embodiment may include a first inner wall S1 having a first inclination angle θ1 at the outermost region and a second inner wall S2 extending from the first inner wall S1 and having a second inclination angle θ2.

Meanwhile, referring to FIG. 12L, in the comparative example, the cavity processing process is performed by allowing an outer portion of the laser beam to be located in the outermost portion of the cavity. Accordingly, an inner wall of the outermost portion of the cavity in the comparative example has an inclination angle of 160 degrees or more. On the other hand, the inner wall of the outermost portion of the cavity of the embodiment has a second inclination angle in the range of 92 to 130 degrees.

For example, in the process in the comparative example, when the cavity is processed in a region with a size of 600 µm, the cavity of 500 µm smaller than 600 µm is formed due to the inclination angle of the inner wall of the cavity. This is because a lower region of the cavity is substantially used as a cavity in which the device is to be mounted, and a space of about 100 µm cannot be used due to the inclination angle of the inner wall.

In contrast, in an embodiment, when the cavity is processed in a region having a size of 600 µm, a cavity having a size of 550 µm larger than that of the comparative example is formed due to the improvement of the inclination angle of the inner wall of the cavity. Accordingly, in an embodiment, a space required for forming a cavity may be reduced, and accordingly, circuit integration may be increased.

Referring to FIG. 12M, a cavity 160a is formed in the second insulating layer 120 using the Gaussian beam as described above. The cavity 160a may mean a cavity formed only by a laser process.

And, referring to FIG. 12N, an embodiment may perform a de-smear process. The de-smear process may be a step of a process of forming a cavity. That is, an embodiment forms a cavity through laser processing, and then, a final cavity 160 is formed through a de-smear process.

The de-smear process may increase an overall width of the cavity while maintaining a shape of the cavity formed by the laser processing as it is. That is, the de-smear process may increase the overall width of the cavity while removing foreign substances contained in the inner wall of the cavity formed by the laser process. As the de-smear process proceeds, the cavity 160 may overlap at least a portion of the first metal layer 143-1 of the third circuit pattern layer 143 in a vertical direction.

Next, the embodiment may proceed with a process of removing a metal layer used as a stopper in a laser process.

For example, the embodiment may proceed with a process of removing a region of the first metal layer 143-1 of the third circuit pattern layer 143 that does not vertically overlap the second metal layer 143-2 by etching. Accordingly, the thickness of the third circuit pattern layer 143 may be changed from the second thickness T2 to the third thickness T3.

In addition, the embodiment may proceed with an etching process of removing a region that vertically overlaps the cavity of the first metal layer 141-1 of the first circuit pattern layer 141 and does not vertically overlap the second metal layer 141-2 of the first circuit pattern layer 141 may be performed. Accordingly, the first-first pattern part 141b and the first-second pattern part 141a of the first circuit pattern layer 141 may be formed. In this case, the first portion 141b1 of the first-first pattern part 141b does not vertically overlap the cavity, but covers the second insulating layer 120, and the second portion 141b2 vertically overlaps the cavity. Accordingly, in the etching process, the first portion 141b1 of the first-first pattern part 141b may not be etched, and the second portion 141b2 may be etched. Accordingly, the first-first pattern part 141b may have a stepped structure.

Next, as shown in FIG. 12O, the embodiment may proceed with a process of forming a first protective layer 151 on the second insulating layer 120 and forming a second protective layer 152 under the third insulating layer 130.

Features, structures, effects, etc. described in the above embodiments are included in at least one embodiment, and are not necessarily limited to only one embodiment. Furthermore, features, structures, effects, etc. illustrated in each embodiment can be combined or modified for other embodiments by those of ordinary skill in the art to which the embodiments belong. Accordingly, the contents related to such combinations and modifications should be interpreted as being included in the scope of the embodiments.

In the above, the embodiment has been mainly described, but this is only an example and does not limit the embodiment, those of ordinary skill in the art to which the embodiment pertains will appreciate that various modifications and applications not illustrated above are possible without departing from the essential characteristics of the present embodiment. For example, each component specifically shown in the embodiment can be implemented by modification. And differences related to such modifications and applications should be construed as being included in the scope of the embodiments set forth in the appended claims.

## Claims

1. A circuit board comprising:
a first insulating layer;
a first circuit pattern layer disposed on one surface of the first insulating layer;
a second insulating layer disposed on the one surface of the first insulating layer and including a cavity; and
a through electrode disposed in a through hole passing through the first insulating layer,
wherein the first circuit pattern layer includes a first pattern part including a portion vertically overlapping an inner wall of the cavity, and
wherein the through electrode includes a first through electrode disposed in a first through hole vertically overlapping the first pattern part.

2. The circuit board of claim 1, wherein an upper surface of the first pattern part is directly connected to a lower end of the inner wall of the cavity.

3. The circuit board of claim 1, further comprising:
a second circuit pattern layer disposed on the other surface of the first insulating layer, and
wherein at least a portion of the second circuit pattern layer vertically overlaps the first through electrode.

4. The circuit board of claim 1, wherein the first pattern part includes:
a first portion vertically overlapping the inner wall of the cavity and having an upper surface in contact with the second insulating layer, and
a second portion extending from the first portion and having an upper surface not in contact with the second insulating layer.

5. The circuit board of claim 4, wherein a thickness of the first portion of the first pattern part is thicker than a thickness of the second portion of the first pattern part.

6. The circuit board of claim 5, wherein the first circuit pattern layer includes:
a second pattern part disposed in a first upper surface region of the upper surface of the first insulating layer that vertically overlaps the cavity; and
a third pattern part disposed in a second upper surface region of the upper surface of the first insulating layer that does not vertically overlap the cavity,
wherein the first pattern part is disposed in a boundary region between the first upper surface region and the second upper surface region.

7. The circuit board of claim 6, wherein the first pattern part is disposed surrounding the boundary region between the first upper surface region and the second upper surface region.

8. The circuit board of claim 6, wherein the thickness of the first portion of the first pattern part is thicker than a thicknesses of each of the second pattern part and the third pattern part.

9. The circuit board of claim 6, wherein the thickness of the second portion of the first pattern part corresponds to a thickness of each of the second pattern part and the third pattern part.

10. The circuit board of claim 6, wherein the first portion and the second portion of the first pattern part include a first metal layer and a second metal layer, respectively,
wherein a thickness of the first metal layer of the first portion is the same as a thickness of the first metal layer of the second portion, and
wherein a thickness of the second metal layer of the first portion is greater than a thickness of the second metal layer of the second portion.
